(19) Europäisches Patentamt
European Patent Office
Office européen des brevets

(11) **EP 3 202 037 B1**

(12) **FASCICULE DE BREVET EUROPEEN**

(45) Date de publication et mention
de la délivrance du brevet:
**13.03.2019   Bulletin 2019/11**

(51) Int Cl.:
*H03H 9/54* *(2006.01)*
*H03H 9/02* *(2006.01)*
*H03H 9/70* *(2006.01)*
*H03H 3/02* *(2006.01)*
*H03H 9/64* *(2006.01)*
*H03H 3/007* *(2006.01)*
*H03H 9/56* *(2006.01)*
*H03H 9/72* *(2006.01)*
*H03H 3/04* *(2006.01)*
*H03H 7/38* *(2006.01)*

(21) Numéro de dépôt: **15731961.7**

(22) Date de dépôt: **29.06.2015**

(86) Numéro de dépôt international:
**PCT/EP2015/064662**

(87) Numéro de publication internationale:
**WO 2016/050375 (07.04.2016 Gazette 2016/14)**

(54) **PROCEDE DE REALISATION COLLECTIVE DE FILTRES A ONDES ACOUSTIQUES**

METHODE ZUM ENTWURF UND DER HERSTELLUNG EINES KOLLEKTIVS AKUSTISCHER FILTER

METHOD FOR DESIGNING AND MANUFACTURING A COLLECTIVE OF ACOUSTIC WAVE FILTERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **29.09.2014   FR 1459210**

(43) Date de publication de la demande:
**09.08.2017   Bulletin 2017/32**

(73) Titulaire: **Commissariat à l'Énergie Atomique et aux Énergies Alternatives
75015 Paris (FR)**

(72) Inventeurs:
• **REINHARDT, Alexandre**
**F-38400 Saint-Martin-d'Heres (FR)**
• **DAVID, Jean-Baptiste**
**F-38000 Grenoble (FR)**

(74) Mandataire: **Esselin, Sophie et al
Marks & Clerk France
Conseils en Propriété Industrielle
Immeuble Visium
22 avenue Aristide Briand
94117 Arcueil Cedex (FR)**

(56) Documents cités:
**US-A1- 2005 212 612     US-A1- 2012 313 731**

• **TOMOYA KOMATSU ET AL: "Tunable Radio-Frequency Filters Using Acoustic Wave Resonators and Variable Capacitors", JAPANESE JOURNAL OF APPLIED PHYSICS, vol. 49, no. 7, 1 juillet 2010 (2010-07-01), page 07HD24, XP055033634, ISSN: 0021-4922, DOI: 10.1143/JJAP.49.07HD24**
• **YAHYA LAKYS ET AL: "Cognitive and encrypted communications, Part 1 : State of the art for frequency-agile filters", ELECTRICAL AND ELECTRONICS ENGINEERING, 2009. ELECO 2009. INTERNATIONAL CONFERENCE ON, IEEE, PISCATAWAY, NJ, USA, 5 novembre 2009 (2009-11-05), pages II-1, XP031581343, ISBN: 978-1-4244-5106-7**

**Description**

Le domaine de l'invention est celui des filtres à ondes acoustiques. Ces filtres sont largement utilisés dans les systèmes de télécommunication mobile pour leur forte compacité et leur caractère passif, associé à de faibles pertes d'insertion et à la possibilité d'assurer une forte réjection des signaux hors de la bande de fréquence désirée.

Nombre de composants électroniques voient leurs caractéristiques électriques entièrement définies par leur géométrie dans le plan. C'est le cas par exemple de transistors. Cette caractéristique offre une grande versatilité dans la réalisation, permettant d'associer sur une même puce des composants aux performances très différentes. Ceci n'est cependant pas le cas des composants à ondes acoustiques de volume (BAW, pour *Bulk Acoustic Wave*), dont les caractéristiques électriques sont entièrement définies par la nature et l'épaisseur des empilements de couches des composants. Même pour des composants à ondes acoustiques de surface (SAW, pour *Surface Acoustic Wave*), où les caractéristiques électriques sont en grande partie définies par les motifs des électrodes employées, les propriétés des ondes exploitées se révèlent sensibles au rapport entre l'épaisseur de ces électrodes et la longueur d'onde, et donc la fréquence. Par conséquent, chaque filtre est à l'heure actuelle réalisé sur une puce propre, ce qui force à assembler un nombre conséquent de puces de filtres (un téléphone portable récent utilise généralement une quarantaine de filtres différents), et impose des schémas d'assemblage complexes.

Pour pallier cette problématique, plusieurs solutions ont été proposées pour permettre de cointégrer plusieurs filtres sur une même puce. Souvent, les réalisations proposées se sont intéressées à la réalisation simultanée des deux filtres d'un duplexeur. Dans ce cas, la séparation entre les deux bandes passantes visées est en effet généralement relativement faible, et la cointégration se justifie par le fait que l'ensemble constitué par les deux filtres doit être ramené sur un substrat comprenant des éléments passifs permettant la réalisation d'une isolation électrique entre voies d'émission et de réception du duplexeur.

Dans le cas de composants SAW, la fréquence de résonance de résonateurs est définie par la période des métallisations en forme de peignes interdigités utilisées pour exciter les ondes acoustiques à la surface de substrats piézoélectriques. L'excitation des ondes acoustiques se fait en effet lorsque la condition de synchronisme $p = \lambda/2 = V/(2f)$ (où $p$ est la période des électrodes interdigitées, $\lambda$ la longueur d'onde, $V$ la vitesse de propagation de l'onde de surface et $f$ la fréquence) est satisfaite.

Afin de réaliser des filtres à des fréquences différentes, l'homme de l'art utilisera donc des périodes d'électrodes différentes pour positionner les différents composants à des fréquences différentes. Il tirera également parti de l'anisotropie des substrats piézoélectriques employés pour bénéficier de conditions de propagation optimales pour fixer les coefficients de couplage électromécaniques des résonateurs (ce qui définit la largeur de bande de chaque filtre) et leur dérive en température. Néanmoins, toutes ces propriétés sont également fortement influencées par le rapport entre l'épaisseur des métallisations et la longueur d'onde, la présence d'une couche métallique rendant les ondes de surface dispersives. Tant que l'espacement en fréquence entre les différents filtres à réaliser est relativement faible, ces effets de dispersion en fréquence restent négligeables. C'est pour cela que certains duplexeurs sont réalisés à partir de deux filtres réalisés conjointement sur une même puce. Toutefois, si les différents filtres que l'on cherche à réaliser présentent une couverture en fréquence significative, ces effets sont prépondérants et peuvent donc affecter les performances d'une partie des filtres à réaliser.

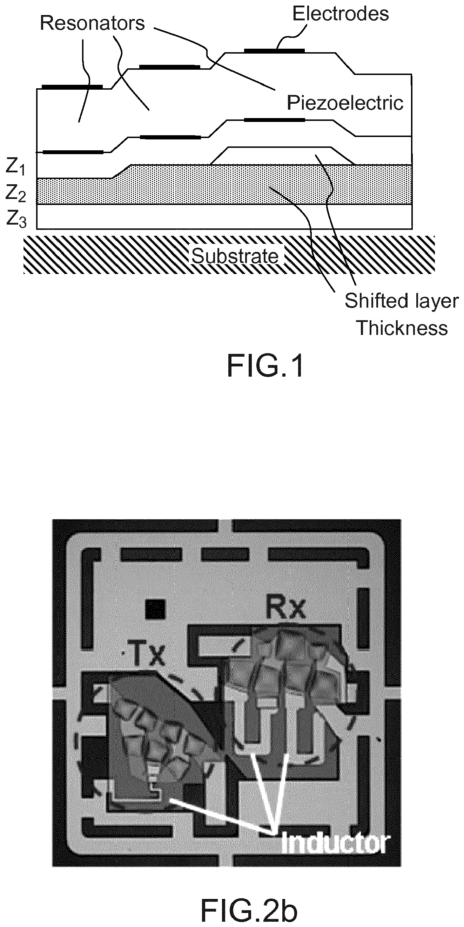

Pour ce qui concerne les filtres à ondes acoustiques de volume (BAW), une première solution proposée dans la littérature consiste à partir d'un filtre de référence, généralement celui qui aura la fréquence centrale la plus élevée. Ce filtre est réalisé à partir de deux jeux de résonateurs à ondes de volume présentant des fréquences de résonance légèrement décalées, ce qui permet de synthétiser un circuit passe-bande à partir de topologies de filtres en échelle ou en treillis. De manière connue, le décalage en fréquence entre ces deux types de résonateurs est obtenu en ajoutant une couche supplémentaire, dite de surcharge massique, sur les résonateurs situés sur les branches parallèles des circuits, de manière à abaisser leur fréquence de résonance par rapport aux résonateurs des branches série. On vient ensuite réaliser le second filtre en utilisant le même principe d'abaissement de la fréquence, c'est-à-dire en ajoutant une couche supplémentaire localisée sous le filtre couvrant la bande de fréquence la plus basse. Ce principe est illustré en figure 1.

Cette solution a été initialement proposée par Lakin en 2000, dans l'article : K.M. Lakin, K.T. McCarron, J. Belsick and R. Rose, Filter banks implemented with integrated thin film resonators, Proceedings of the 2000 IEEE Ultrasonics Symposium, pp. 851-854 (2000) et a été démontrée expérimentalement en 2008 par Nam et décrite dans l'article : Nam et al., Monolithic 1-chip FBAR duplexer for W-CDMA handsets, Sensors and Actuators A, vol. 143, pp.162-169 (2008), qui a réalisé simultanément les filtres de réception et de transmission d'un duplexeur pour le standard WCDMA. Cette démonstration utilise des filtres de type FBAR (*Film Bulk Acoustic Resonator*), mais son principe peut être directement appliqué à des résonateurs de type SMR (*Solidly Mounted Resonator).*

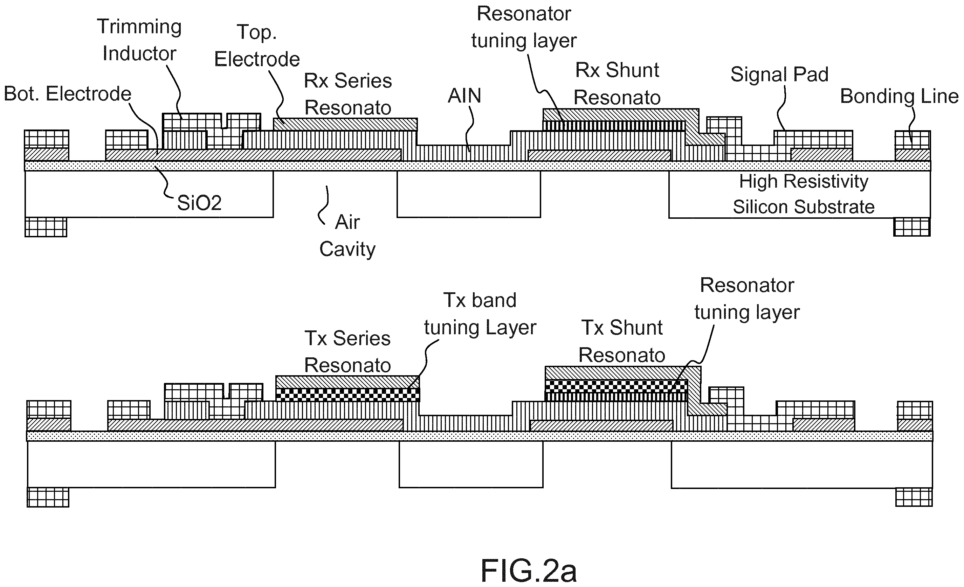

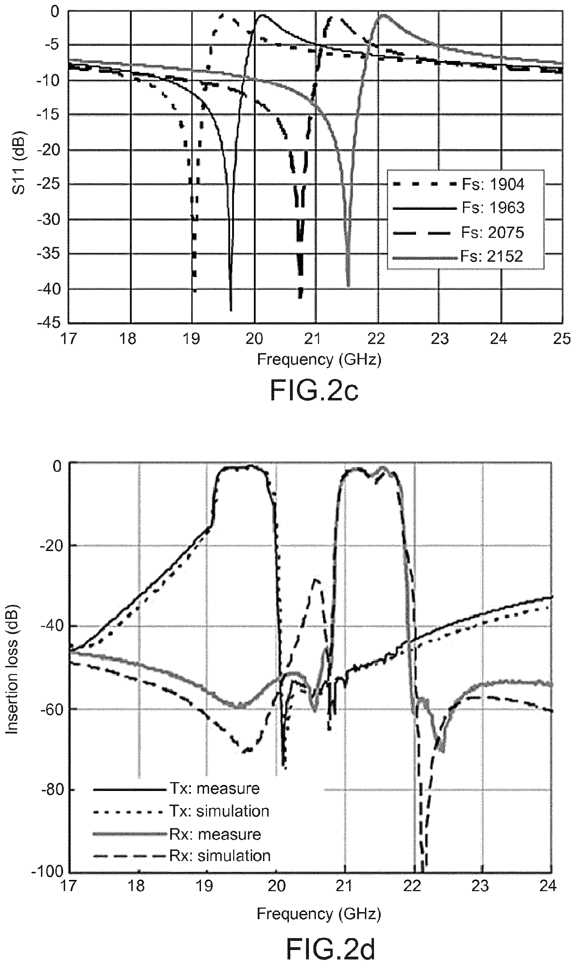

Pour réaliser simultanément les deux filtres d'un duplexeur, il est en théorie nécessaire d'utiliser trois couches de surcharge massique, puisqu'en définitive l'on doit réaliser un jeu de quatre résonateurs décalés en fréquence. Dans leurs travaux, les auteurs de cette publication ont pu optimiser la conception des empilements pour pouvoir réduire le nombre de couches de surcharge massique et ainsi simplifier la réalisation. Ainsi, l'empilement du filtre de transmission ne diffère de celui de réception que par l'ajout local d'une couche « de décalage de bande » (*band tuning layer* dans la publication d'origine). Ceci est illustré sur les figures 2a à 2d relatives à un exemple de réalisation des deux filtres d'un duplexeur WCDMA dans l'article de Nam et al., Monolithic 1-chip FBAR duplexer for W-CDMA handsets, Sensors and Actuators A, vol. 143, pp. 162-169 (2008).

L'avantage de cette solution est que le surcoût technologique associé à sa réalisation ne consiste qu'en un niveau de masque de photolithographie et une étape de dépôt et de structuration. Cette solution reste donc très simple à mettre en oeuvre. Néanmoins, l'ajout d'une couche additionnelle sur certains résonateurs provoque en pratique une réduction du coefficient de couplage électromécanique, ce qui peut se traduire par des pertes d'insertion supplémentaires et/ou par une ondulation de la transmission dans la bande de fréquence visée, et/ou par une réduction de la bande passante effective du filtre ainsi réalisé, ce qui dégrade les performances du composant. Cette dégradation est d'autant plus forte que l'espacement en fréquence entre les filtres est grand, étant donné qu'il faut recourir dans ce cas à une surcharge massique plus importante. En pratique, donc, cette solution ne peut être employée que dans des configurations dans lesquelles la couverture fréquentielle visée n'est pas très large. Dans le cas du duplexeur WCDMA présenté dans la référence précitée de Nam et al. , les deux filtres ont une largeur de bande passante relative d'environ 3%, et sont espacés en fréquence de 9%. La structure FBAR utilisée peut supporter ces contraintes. Néanmoins, de nombreuses autres bandes de fréquences radios se montrent plus problématiques.

Des équipes de l'institut VTT ont d'ailleurs démontré que couvrir efficacement plusieurs bandes par des composants BAW suppose des épaisseurs de matériau piézoélectrique différentes au niveau de chacun des filtres, comme décrit dans J. Ellä and H. Pohjonen, *BAW filters having different center frequencies on a single substrate and a method for providing the same,* Brevet US 6,518,860 B2. Les contraintes sur la synthèse de filtre sont en effet telles que le matériau piézoélectrique utilisé pour réaliser les résonateurs à ondes de volume, le nitrure d'aluminium, possède tout juste les propriétés piézoélectriques suffisantes pour les satisfaire. En matière de dimensionnement, tout se passe donc comme si l'on cherchait à réaliser chaque filtre sur une puce différente. En termes de fabrication, les choses deviennent plus complexes.

Une première approche proposée dans le brevet en question consiste à déposer une première couche de matériau piézoélectrique, sur une épaisseur correspondant à la plus petite des épaisseurs de matériau nécessaire. On vient ensuite protéger cette couche aux endroits où sera localisé le filtre nécessitant cette épaisseur, généralement le filtre le plus haut en fréquence. On procède ensuite à un nouveau dépôt du matériau piézoélectrique, ce qui a pour effet d'épaissir cette couche aux endroits où elle n'est pas protégée, c'est-à-dire là où le filtre le plus bas en fréquence est situé.

La faisabilité de cette approche a été étudiée par une équipe de l'Ecole Polytechnique Fédérale de Lausanne décrit dans : F. Martin, P. Muralt, M. Cantoni and M.A. Dubois, Re-growth of c-axis oriented AIN thin films, Proceedings of the 2004 IEEE Ultrasonics Symposium, pp. 169-172 (2004).

Les auteurs ont montré qu'en pratique cette approche de recroissance de la couche conduit à une diminution de ses propriétés piézoélectriques par rapport à un dépôt direct d'une épaisseur équivalente. Ils mettent en évidence que ceci est lié au fait que, dans le cas du nitrure d'aluminium (AIN), la surépaisseur ajoutée présente soit une mauvaise cristallinité, soit même une inversion de sa polarité, ce qui entraîne une annulation partielle de l'effet piézoélectrique induit par la couche d'origine. Ce comportement est attribué à une dégradation de la surface de la couche d'AIN provoqué par les agents chimiques utilisés durant les étapes de procédé de fabrication en salle blanche (photolithographies notamment), qui sont connus pour graver légèrement le matériau et pour augmenter sa rugosité. Ce phénomène est également visible après une simple remise à l'air du matériau après dépôt, même si l'effet est moindre dans ce cas. Ceci signifie qu'une simple oxydation ou une réaction avec l'humidité de l'air suffit à provoquer une dégradation de surface et à empêcher une recroissance conservant la polarité du matériau. Cette étude montre donc qu'une telle approche, au moins dans le cas de l'AIN, n'est pas viable.

L'homme de l'art pourrait envisager de prendre le contrepied de l'approche précédente, et envisager de déposer la couche piézoélectrique la plus épaisse en premier, puis de venir la graver localement afin de l'amincir jusqu'à l'épaisseur désirée pour les filtres aux fréquences les plus hautes. Ceci présente l'avantage de conserver l'intégrité structurelle du matériau. Néanmoins, cette approche s'accompagne de deux défauts rédhibitoires :

- la gravure peut entraîner une rugosification de la couche partiellement gravée, ce qui se traduit par une dégradation du coefficient de qualité des résonateurs. Pire, dans le cas de résonateurs en nitrure d'aluminium, les produits chimiques utilisés pour les étapes de photolithographie et de retrait de résine entrainent également une dégradation de l'état de surface du matériau ;
- d'autre part, les résonateurs sont très sensibles à l'épaisseur de la couche piézoélectrique. D'énormes progrès ont été menés pour amener les techniques de dépôt de couches minces piézoélectriques (notamment d'AIN) jusqu'à un niveau satisfaisant de maîtrise de l'épaisseur (atteignant couramment en production une incertitude sur l'épaisseur déposée présentant un écart-type de l'ordre de 0.3 % de l'épaisseur visée). Dans une approche consistant à amincir localement la couche piézoélectrique, la dispersion résiduelle d'épaisseur cumule les incertitudes d'épaisseur liées au dépôt de la couche aux dispersions apportées par la gravure, qui sont généralement relativement importantes, surtout pour une gravure partielle sans couche d'arrêt. Une telle approche conduirait donc à des dispersions de fréquence significatives, ce qui se traduirait par des chutes de rendement de fabrication.

Pour pallier les limitations de ces deux dernières approches, l'Université Polytechnique de Madrid a proposé une approche applicable aux résonateurs BAW en AlN, en tirant partie des particularités technologiques des empilements habituellement utilisés comme décrit dans la demande internationale de brevet de E. Iborra, M. Clement, J. Olivares, *Device for filtering bulk acoustic waves,* WO2010/116011 A1 (2010).

Le principe de cette approche consiste à déposer en premier lieu une première couche piézoélectrique de nitrure d'aluminium, puis à la recouvrir d'une couche faisant office de masque dur. Ceci peut par exemple être la couche métallique formant l'électrode supérieure. On vient ensuite définir ce masque dur pour le retirer aux endroits où l'on voudra réaliser les autres séries de filtres. On procède ensuite à la gravure du nitrure d'aluminium pour ne laisser subsister que des ilots sur lesquels seront fabriqués la première série de filtres. On vient ensuite refaire un dépôt de la seconde couche de nitrure d'aluminium, visant une épaisseur correspondant à la seconde série de filtres. Cette seconde couche est à nouveau recouverte d'un masque dur, qui est défini à son tour pour dégager les espaces où l'on n'aura pas besoin de la seconde épaisseur de matériau piézoélectrique. On procède alors à la gravure de la seconde couche de nitrure d'aluminium. A ce stade, la gravure va butter soit sur le premier masque dur, ce qui permet de retirer la seconde couche d'AlN et de protéger l'ilot restant de la première couche ; soit sur le second masque dur, ce qui protège la seconde couche d'AlN, qui a été déposée sur une surface d'où la première couche a déjà été retirée au préalable. On forme ainsi des ilots présentant des épaisseurs distinctes. Le procédé peut ensuite être répété à l'envi. Il suffit ensuite de graver les masques durs, en tirant parti de la sélectivité de gravure entre ces masques et l'AlN, ce qui garantit que les couches piézoélectriques ne seront pas dégradées. Dans le cas où ce masque dur est réalisé à partir des couches métalliques constituant les électrodes supérieures (en Mo dans le brevet en question), on peut directement utiliser cette étape de gravure pour venir former les motifs des électrodes supérieures. Si cela est fait par gravure sèche réactive utilisant des gaz fluorés, le procédé est extrêmement sélectif vis-à-vis de la couche de nitrure d'aluminium, ce qui permet de s'accommoder d'épaisseurs différentes sur chacun des ilots sans impact sur le procédé de réalisation.

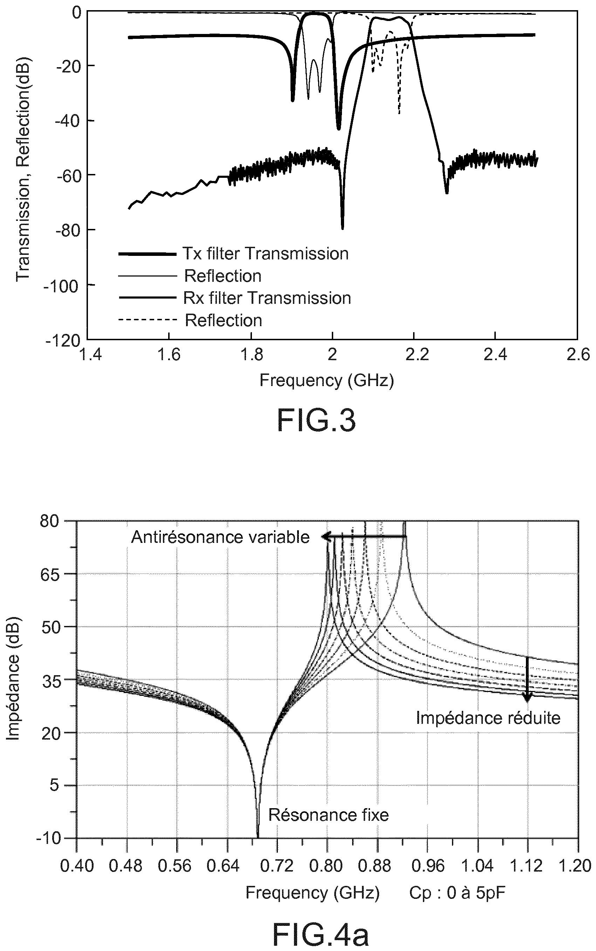

Cette approche a été validée expérimentalement par le Demandeur et décrite dans l'article : A. Reinhardt, J.B. David, C. Fuchs, M. Clement, J. Olivares, E. Iborra, N. Rimmer, S. Burgess, Multiple-frequency solidly mounted BAW filters, Proceedings of the 2011 International Frequency Control Symposium, peu après en prenant le cas des deux filtres d'un duplexeur pour le standard WCDMA. Cet article montre une coupe des deux empilements réalisés pour les différents filtres, qui diffèrent de par l'épaisseur de la couche de nitrure d'aluminium qui est de 1.29 $\mu$m pour le filtre d'émission ou de 1.11 $\mu$m pour le filtre de réception. Cet article montre également les réponses des deux filtres réalisés conjointement, et la validité de l'approche comme repris et illustré en figure 3.

Cette approche présente cependant encore quelques limitations :

- elle nécessite un certain nombre d'étapes de fabrication supplémentaires pour former les ilots de couches piézoélectriques possédant des épaisseurs différentes. Elle entraine donc un surcoût de fabrication qui est à mettre en regard du surcoût à l'assemblage sur un même module de deux puces différentes au lieu d'une seule contenant les deux filtres cointégrés ;
- par ailleurs, pour limiter le coût technologique de cette approche, il convient d'établir des empilements technologiques pour chaque filtre en essayant de conserver un maximum de couches d'épaisseurs identiques entre les différents filtres. Pour des applications critiques au niveau performances, les technologies à base de nitrure d'aluminium peuvent ne pas être capables de laisser au concepteur suffisamment de degrés de liberté pour autoriser un tel partage de couches entre différents filtres, car ses propriétés sont tout juste capables de répondre aux spécifications des filtres existants.

Au vu de ce constat, et face à la multiplication du nombre de filtres dans les systèmes de communication mobile, il reste nécessaire d'identifier une technologie capable de synthétiser la plupart des filtres passe bande nécessaire au fonctionnement de ces systèmes, permettant de cointégrer un maximum d'entre eux sur une même puce, et idéalement sans surcoût technologique.

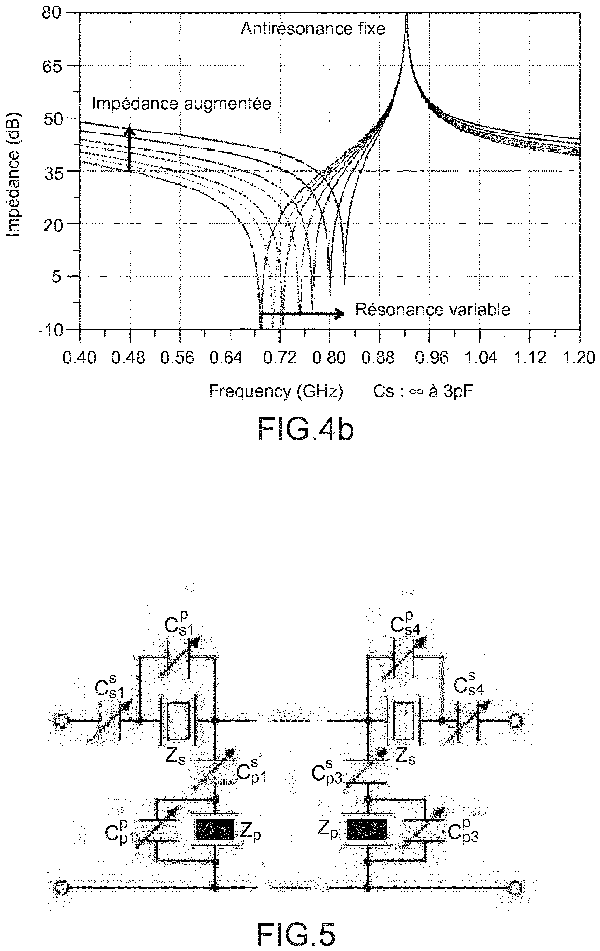

Une solution à cette problématique a été indirectement apportée par l'équipe du Pr. Hashimoto de l'université de Chiba. Cette équipe s'intéresse en effet depuis quelques années à l'utilisation de résonateurs à très grands coefficients de couplage électromécaniques en vue de réaliser des filtres agiles en fréquence : K. Y. Hashimoto, S. Tanaka, M. Esashi, Tunable RF SAW/BAW filters: dream or reality? , 2011 Joint Conference of the IEEE International Frequency Control Symposium and the European Frequency and Time Forum. En effet, l'ajout d'éléments passifs variables en série ou en parallèle à un résonateur acoustique permet de déplacer les fréquences de résonance et d'antirésonance comme illustré sur les figures 4a et 4b.

Il est donc possible de déplacer de manière importante les fréquences de résonance et d'antirésonance d'un résonateur dans les limites de l'intervalle délimité par les fréquences de résonance et d'antirésonance d'origine, dépourvu des éléments capacitifs d'ajustement. Un très grand coefficient de couplage électromécanique devient la condition nécessaire à une très grande agilité en fréquence. Pour exploiter ce principe, on utilise des topologies de filtres telles que par exemple celle présentée sur la figure 5. En prenant le parti d'exploiter des résonateurs SAW présentant des coefficients de couplage électromécanique les plus élevés possible (ici, supérieur à 30 %), ces auteurs sont parvenus à concevoir un circuit de filtre possédant une largeur de bande relative de 5 % capable de voir sa fréquence centrale varier de 5 %. Pour démontrer ce principe de filtre variable, les auteurs ont en pratique réalisé deux filtres distincts, possédant des résonateurs identiques et des valeurs de capacités différentes comme décrit dans : T. Komatsu, K.Y. Hashimoto, T. Omori, M. Yamaguchi, Tunable radio-frequency filters using acoustic wave resonators and variable capacitors, Japanese Journal of Applied Physics 49, 2010, plutôt que de réaliser directement un module complet de filtre agile en fréquence. En cela, ils ont proposé, de manière fortuite une solution permettant de réaliser deux filtres opérant à des fréquences différentes sur une même puce.

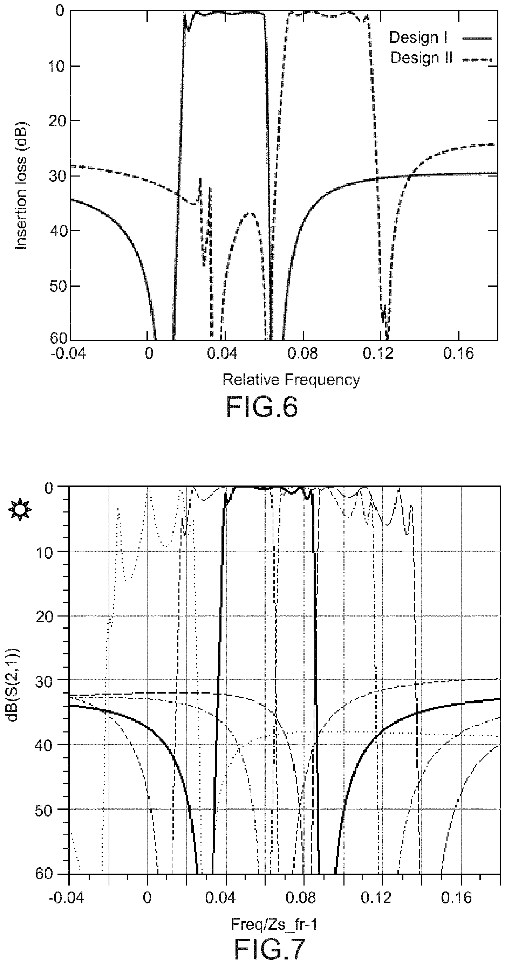

Faire varier la fréquence centrale d'un filtre selon cette approche, même si elle est fonctionnelle, se heurte cependant à une forte limite. En effet, les auteurs de l'université de Chiba présentent, comme illustré sur la figure 6, deux filtres de 5 % de bande relative, centrés à 4 et 9 % d'une fréquence de référence. Néanmoins, ayant basé leur filtre sur des résonateurs présentant un coefficient de couplage électromécanique de 30 %, on pourrait espérer une agilité en fréquence - ou bien un espacement en fréquence entre les deux filtres - bien supérieur.

En pratique, dans l'approche proposée par l'équipe de l'université de Chiba, la variation de fréquence apportée par une modification des valeurs des capacités insérées dans le circuit de filtre est limitée par le fait que l'impédance caractéristique des résonateurs est modifiée par la valeur des capacités mises en série et en parallèle avec les résonateurs, comme le font apparaître les figures 4a et 4b. Ainsi, dès lors que l'on fait varier fortement les valeurs des éléments passifs dans le but d'augmenter l'espacement en fréquence entre les deux filtres, on entraîne très vite une désadaptation électrique du filtre, ce qui le rend non fonctionnel. Cet effet est illustré sur la figure 7 qui représente la dégradation de la réponse d'un filtre à mesure que l'on cherche à déplacer sa fréquence en jouant sur les valeurs de capacités insérées dans le circuit du filtre.

Dans ce contexte, la présente invention propose une solution afin de permettre la réalisation collective de plusieurs filtres à ondes acoustiques en utilisant pour cela des résonateurs à très forts coefficients de couplage électromécanique, typiquement supérieurs à 15% et avantageusement supérieurs à 30% auxquels on adjoint des éléments réactifs en série et en parallèle de manière à déplacer les fréquences de résonance et d'antirésonance naturelles de ces résonateurs, et ainsi de générer plusieurs couples de fréquences de résonance / antirésonance permettant de réaliser à partir d'une structure de résonateur de base commune aux filtres, des filtres présentant des fréquences centrales et des largeurs de bande distinctes.

Néanmoins, pour éviter de subir les limitations existantes dans la réalisation présentée dans l'article de T. Komatsu, K.Y. Hashimoto, T. Omori, M. Yamaguchi, Tunable radio-frequency filters using acoustic wave resonators and variable capacitors, le Demandeur propose dans la présente invention de réaliser les briques élémentaires des filtres que l'on veut synthétiser, à savoir les triplets résonateur / réactance série / réactance parallèle d'une manière telle qu'ils présentent les impédances nécessaires au bon fonctionnement du filtre dans lesquels ils seront insérés.

Plus précisément la présente invention a pour objet un procédé selon la revendication 1.

Selon la présente invention, tous les résonateurs réels des filtres peuvent avantageusement être cointégrés sur une même puce et ce de manière optimisée à partir d'une structure de base standard.

Selon des variantes de l'invention, la brique élémentaire comprend une réactance montée en parallèle reliée d'une part à une borne d'entrée/sortie et d'autre part à un noeud intermédiaire entre le résonateur et une réactance montée en série.

Selon des variantes de l'invention, la brique élémentaire comprend une réactance montée en parallèle de l'ensemble résonateur / réactance série.

Selon des variantes de l'invention, les filtres comprennent des briques élémentaires montées en série et des briques élémentaires montées en parallèle.

Selon des variantes de l'invention, les résonateurs étant des résonateurs à ondes de volume, le procédé comprend :

- la réalisation d'au moins un empilement comportant une couche d'électrode inférieure, une couche de matériau piézoélectrique, une couche d'électrode supérieure permettant de définir le résonateur de conception de référence ;
- la détermination des dimensions géométriques de la surface active des résonateurs réels.

Selon des variantes de l'invention, le procédé comporte la réalisation de plusieurs empilements formés à partir d'une même couche piézoélectrique ou de plusieurs couches piézoélectriques .

Dans le cas de l'utilisation de plusieurs couches piézoélectriques celles-ci sont de préférence adjacentes les unes aux autres et présentent des épaisseurs différentes, elles sont associées respectivement à des couches d'électrodes distinctes ou communes.

Selon des variantes de l'invention, les résonateurs réels et de référence des briques élémentaires montées en parallèle comprennent une surcharge massique par rapport aux résonateurs réels et de référence des briques élémentaires montées en série.

Selon des variantes de l'invention, l'empilement comprend une couche de passivation dans laquelle l'épaisseur permet de réaliser les surcharges massiques.

Selon des variantes de l'invention, les résonateurs sont des résonateurs à ondes de surface, le procédé comprend :

- la définition d'une structure de résonateur de référence comportant une structure de peignes d'électrodes inter-digitées de période À,
- la détermination des longueurs de peignes d'électrodes interdigités de même période À, permettant de définir les ensembles de j résonateurs réels.

Selon des variantes de l'invention, les résonateurs réels et de référence sont réalisés sur un substrat en LiNbO$_3$, pouvant être avantageusement d'orientation cristalline (YXI)/15°, les peignes d'électrodes étant réalisés en cuivre.

Selon des variantes de l'invention, les résonateurs sont des résonateurs à ondes de plaque, le procédé comprend :

- la réalisation d'une membrane et d'une structure de peignes d'électrodes inter-digitées de période $\lambda$ permettant de définir un résonateur de référence ;
- la détermination des longueurs de peignes d'électrodes interdigités de même période À, permettant de définir les ensembles de j résonateurs réels.

Selon des variantes de l'invention, les résonateurs réels et de référence sont réalisés sur un substrat en LiNbO$_3$, pouvant être avantageusement de coupe d'orientation cristalline (YXI)/30°.

Selon des variantes de l'invention, l'association de réactances série et/ou parallèle avec lesdits résonateurs réels est effectuée au niveau d'une puce commune auxdits résonateurs réels et auxdites réactances.

Selon des variantes de l'invention, le procédé comprend :

- la réalisation des résonateurs réels par un empilement, réalisé au-dessus d'une cavité libérée dans un substrat ;
- à proximité de ces résonateurs, la réalisation des capacités permettant de positionner les fréquences de résonance et d'antirésonance à partir d'un autre empilement.

Selon des variantes de l'invention, l'empilement formant les résonateurs et l'empilement formant les capacités comportent au moins une couche commune constituée par une couche piézoélectrique.

L'invention sera mieux comprise et d'autres avantages apparaîtront à la lecture de la description qui va suivre donnée à titre non limitatif et grâce aux figures annexées parmi lesquelles :

- la figure 1 illustre le principe de cointégration de deux filtres par utilisation d'une couche de surcharge massique pour abaisser la fréquence centrale de l'un d'entre eux, selon l'art connu ;
- les figures 2a à 2d sont relatives à un exemple de réalisation des deux filtres d'un duplexeur WCDMA et illustrent des empilements du filtre de réception et de transmission révélant l'ajout d'une couche additionnelle sur les résonateurs du filtre de transmission (figure 2a) ; à une photographie optique du duplexeur ainsi réalisé sur une unique puce (figure 2b) ; aux réponses électriques respectivement des résonateurs (figure 2c) et des filtres obtenus (figure 2d) ;
- la figure 3 illustre la mesure électrique des filtres de réception et d'émission WCDMA cointégrés selon l'article de A. Reinhardt, J.B. David, C. Fuchs, M. Clement, J. Olivares, E. Iborra, N. Rimmer, S. Burgess ;
- les figures 4a et 4b illustrent l'effet d'une capacité en parallèle et d'une capacité en série sur la réponse électrique d'un résonateur selon l'art connu ;
- la figure 5 illustre le principe d'un filtre contenant des résonateurs auxquels sont adjoints des capacités variables en série et en parallèle selon l'art connu ;
- la figure 6 illustre des exemples de filtre réalisés à partir de la topologie illustrée en figure 5, obtenue en faisant varier les valeurs des capacités du circuit de filtre selon l'art connu ;
- la figure 7 illustre la désadaptation des filtres lorsqu'ils sont centrés au-delà de 0 % ou de 11 % de la fréquence de résonance des résonateurs série selon l'art connu ;
- la figure 8 illustre un premier exemple de brique élémentaire utilisée dans la présente invention pour composer les filtres réalisés collectivement ;

- la figure 9 illustre le schéma équivalent d'un résonateur dit de Butterworth-Van Dyke modifié ;
- la figure 10 illustre la définition des fréquences de résonance et d'antirésonance d'un résonateur piézoélectrique en lien avec le schéma de équivalent de Butterworth-Van Dyke modifié ;
- la figure 11 illustre un second exemple de brique élémentaire utilisée dans la présente invention pour composer les filtres réalisés collectivement ;
- la figure 12 illustre l'architecture de filtre en échelle utilisée pour chaque filtre dans un exemple de réalisation de la présente invention ;
- la figure 13 illustre la réponse fréquentielle de l'architecture de la figure 12, configurée pour les bandes TX 28, 17, 13 et 5 (échelle de gauche, en dB) et la réponse fréquentielle du doublet de résonateurs à base de LNO, conçus pour réaliser ces filtres (échelle de droite, en Ohms) ;
- la figure 14 illustre la réponse fréquentielle de l'architecture de la figure 12, configurée pour les bandes RX 28, 17, 13 et 5 (échelle de gauche, en dB) et la réponse fréquentielle du doublet de résonateurs à base de LNO, conçus pour réaliser l'ensemble de ces filtres (échelle de droite, en Ohms) ;
- la figure 15 illustre une vue schématique en coupe d'une portion de filtre incluant un résonateur et trois capacités cointégrées selon le procédé de l'invention ;
- la figure 16 illustre une vue schématique de dessus d'une portion du filtre de transmission de la bande 28 et réalisé en cointégrant les capacités et les résonateurs.

De manière générale, comme il a été précédemment explicité , le Demandeur propose de réaliser des briques élémentaires pour élaborer les filtres que l'on veut synthétiser, à savoir les triplets résonateur / réactance série / réactance parallèle d'une manière telle qu'ils présentent les impédances ou admittances (inverse de l'impédance) nécessaires au bon fonctionnement du filtre dans lesquels ils seront insérés.

Premier exemple de brique élémentaire pouvant être utilisé dans la présente invention :

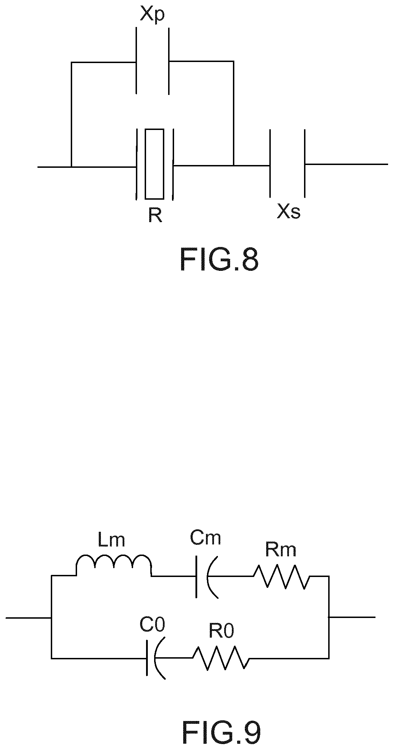

La brique élémentaire de cet exemple est représentée sur la figure 8 : elle est constituée d'un résonateur R, d'une réactance (exemple représenté d'une capacité) Xp en parallèle avec le résonateur, et d'une autre réactance (exemple représenté d'une capacité) Xs en série avec le résonateur. Il est à noter que les réactances placées en série ou en parallèle au résonateur peuvent être des inductances. Il est même possible d'envisager de mélanger capacités et inductances tant que l'ensemble adjoint au résonateur reste globalement réactif.

De manière générale, l'impédance Zr d'un résonateur électromécanique est caractérisée, quelle que soit sa nature (SAW, BAW, Lamb, ...) et en première approche, par l'impédance de son modèle équivalent, dit de Butterworth-Van Dyke et représenté sur la figure 9, et fournie, en négligeant les pertes, par la relation :

$$Z_r = \frac{1}{Y_r}$$

avec

$$Y_r = j\omega\left(\frac{L_m C_m C_0 \omega^2 - C_0 - C_m}{L_m C_m \omega^2 - 1}\right)$$

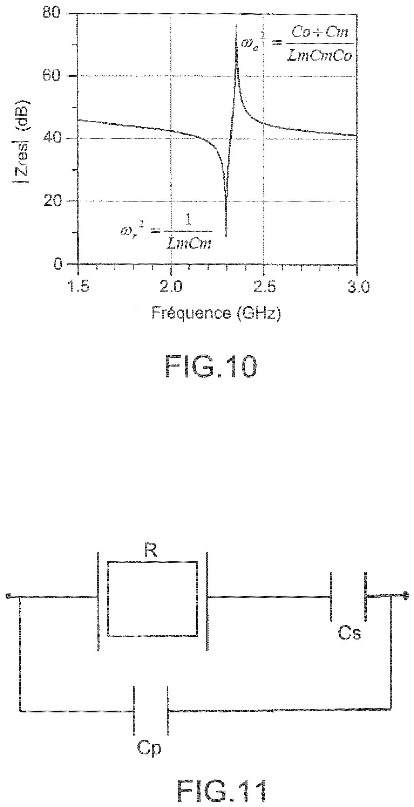

La courbe de la figure 10 correspond au tracé de l'impédance telle que définie par la formule précédente.

Les composantes de la branche motionnelle ($L_m$, $C_m$ et $R_m$) sont reliées à la résonance acoustique, et donc aux caractéristiques de l'empilement technologique du résonateur, tandis que la branche électrostatique ($C_0$) est liée aux dimensions géométriques du résonateur.

A ce titre, les valeurs des éléments de la branche motionnelle sont calculées de manière à rendre compte des fréquences de résonance $\omega_r$ et d'antirésonance $\omega_a$ selon les équations suivantes :

$$\omega_r{}^2 = \frac{1}{L_m C_m} \qquad \omega_a{}^2 = \frac{C_0 + C_m}{L_m C_m C_0} = \omega_r{}^2(1 + r)$$

avec

$$r = \frac{C_m}{C_0}$$

Par ailleurs, l'impédance caractéristique $Z_C$ du résonateur en dehors des fréquences remarquables peut être définie en éliminant l'effet piézoélectrique, $Z_C$ correspondant alors à l'impédance d'un condensateur de capacité $C_0$.

De manière simplifiée, on peut donc exprimer la réponse électrique d'un résonateur à partir de l'impédance (ou l'admittance) caractéristique du résonateur.

$$Y_r = jC_0\omega \left( 1 + \frac{r}{1 - \left(\frac{\omega}{\omega_r}\right)^2} \right) = Y_C \left( 1 + \frac{r}{1 - \left(\frac{\omega}{\omega_r}\right)^2} \right)$$

Où $Y_c = jC_0\omega$ est l'admittance de la branche électrostatique seule, et donc la grandeur fixant l'impédance caractéristique du résonateur.

Lorsque l'on associe des composants en série et en parallèle avec ce résonateur, on obtient une nouvelle impédance $Z_{eq}$, caractérisée par de nouvelles fréquences de résonance et d'antirésonance, et une nouvelle impédance caractéristique.

En notant $Y_{eq}$ l'admittance équivalente de l'ensemble constitué par un résonateur d'admittance caractéristique $Y_C$, de fréquence $\omega_r$, et de deux éléments d'admittance $Yp$ et $Y_S$ respectivement disposés en série et en parallèle, on obtient :

$$Y_{eq} = \frac{Y_S \left( Y_P + Y_C \left( 1 + \frac{r}{1 - \left(\frac{\omega}{\omega_r}\right)^2} \right) \right)}{Y_S + Y_P + Y_C \left( 1 + \frac{r}{1 - \left(\frac{\omega}{\omega_r}\right)^2} \right)}$$

L'admittance caractéristique de cet ensemble est obtenue lorsque l'on observe la réponse à haute fréquence (comme pour un résonateur simple) :

$$Y_{C,eq} = \frac{Y_S \left( Y_P + Y_C \right)}{Y_S + Y_P + Y_C}$$

La fréquence de résonance effective est caractérisée par une annulation du dénominateur de $Y_{eq}$ et correspond

donc à :

$$\omega_{r,eq} = \omega_r \sqrt{1 + \frac{r \cdot Y_C}{Y_S + Y_P + Y_C}}$$

De même, la fréquence d'antirésonance effective est caractérisée par une annulation du numérateur de $Y_{eq}$, et correspond donc à :

$$\omega_{a,eq} = \omega_r \sqrt{1 + \frac{r \cdot Y_C}{Y_P + Y_C}}$$

Ces trois dernières équations montrent qu'à partir d'un résonateur réel présentant des fréquences de résonance et d'antirésonance naturelles données, il est possible de générer, par :

- un dimensionnement adéquat de la capacité statique (obtenu en définissant la surface active du résonateur pour un résonateur BAW, ou le nombre de peignes interdigités pour un résonateur SAW) et par ;
- l'adjonction d'éléments réactifs en série et en parallèle (l'adjonction d'éléments non réactif conduisant à des fréquences de résonance et d'antirésonance complexes, c'est-à-dire à un résonateur à pertes),

n'importe quelle réponse de résonateur équivalent présentant une impédance, et des fréquences de résonance et d'antirésonance équivalentes choisies.

En d'autres termes, il existe toujours un unique jeu de paramètres ($Y_C$, $Y_S$ et $Y_p$) permettant d'établir un résonateur équivalent présentant un triplet ($Y_{c,eq}$, $\omega_{r,eq}$ et $\omega_{a,eq}$) choisi.

En jouant donc sur les dimensions géométriques du résonateur et sur les valeurs des réactances adjointes en série et en parallèle, on peut positionner librement un pôle et un zéro, associés à une impédance caractéristique choisie.

Association d'un résonateur avec des capacités en série et en parallèle :

Le cas le plus naturel est celui où l'on associe un résonateur à une capacité en série et à une autre en parallèle. Les équations (1), (2) et (3) se simplifient dans ce cas :

$$\omega_{r,eq} = \omega_r \sqrt{1 + r \cdot \frac{C_0}{C_0 + C_p + C_s}} \qquad \omega_{a,eq} = \omega_r \sqrt{1 + r \cdot \frac{C_0}{C_0 + C_p}}$$

Par ailleurs, cette brique de base présente une impédance caractéristique $Z_{C,eq}$ différente de celle du résonateur d'origine, caractérisée par une capacité statique équivalente égale à :

$$C_{0,eq} = \frac{(C_0 + C_p) \cdot C_s}{C_0 + C_p + C_s}$$

La plage d'exploitation de ces paramètres est limitée à des valeurs de $C_0$, $C_S$ et $C_p$ positives. De plus, les valeurs de fréquences de résonance et d'antirésonance atteignables sont limitées dans la gamme définie par l'intervalle entre les fréquences de résonance et d'antirésonance du résonateur d'origine.

Il est possible de décliner de la même manière les équations des autres configurations d'association entre un résonateur et des éléments réactifs, pour s'apercevoir que d'autres champs de solutions apparaissent alors.

Association d'un résonateur avec des inductances en série et en parallèle :

De la même manière que précédemment, les fréquences de résonance et d'antirésonance équivalentes sont obtenues par les équations (2) et (3), avec $Y_S$ et $Yp$ les admittances d'inductances en série et en parallèle . Moyennant quelques calculs, on obtient :

$$\omega_{r,eq} = \sqrt{\frac{1}{2}\left(\frac{1}{L_{//}C_0} + \omega_a{}^2\right)\left(1 \pm \sqrt{1 - \left(\frac{4\omega_r{}^2}{1+\omega_a{}^2 L_{//}C_0}\right)^2}\right)},$$

$$\omega_{a,eq} = \sqrt{\frac{1}{2}\left(\frac{1}{L_p C_0} + 1 + r\right)\left(1 \pm \sqrt{1 - \frac{4\omega_r{}^2}{\left(\frac{1}{L_p C_0}+1+r\right)^2}}\right)},$$

$$C_{0,eq} = \frac{1 - L_p C_0 \omega^2}{\dfrac{L_p + L_s}{L_p C_0}\left(1 - \dfrac{\omega^2}{L_{//}C_0}\right)},$$

$$L_{//} = \frac{L_p \cdot L_s}{L_p + L_s}.$$

avec

On constate que l'on peut toujours écrire les équations permettant de déterminer ($C_{0,eq}$, $\omega_{r,eq}$ et $\omega_{a,eq}$) en fonction de ($C_0$, $L_S$, $L_p$).

Cependant dans ce cas, deux solutions de fréquences de résonance et d'antirésonance sont possibles, provoquées par un dédoublement de la résonance. De plus, la capacité statique équivalente dépend désormais de la fréquence, et présente un pôle à la fréquence de résonance du circuit formé par la capacité statique du résonateur et des inductances adjointes. Pour cette raison, ce type de circuit n'est pas celui qui est privilégié.

Association d'un résonateur avec une inductance en série et une capacité en parallèle :

De la même manière que précédemment, on obtient dans ce cas :

$$\omega_{r,eq} = \sqrt{\frac{1 \pm \sqrt{1 - \frac{4L_s(C_0 + C_p)\omega_r{}^2}{(1 + L_s C_0 \omega_a{}^2)^2}}}{2L_s(C_0 + C_p)}},$$

$$\omega_{a,eq} = \omega_r \cdot \sqrt{1 + r \cdot \frac{C_0}{C_0 + C_p}},$$

$$C_{0,eq} = \frac{C_0 + C_p}{1 - L_s \cdot (C_0 + C_p)\omega^2}.$$

La fréquence d'antirésonance ne dépend donc que de la capacité en parallèle, tandis que la fréquence de résonance est sensible aux deux composants ajoutés. Par ailleurs, la fréquence de résonance est double, et la capacité statique équivalente dépend de la fréquence. Comme dans le cas précédent, cette association n'est pas privilégiée.

Association d'un résonateur avec une capacité en série et une inductance en parallèle :

De la même manière que précédemment, les fréquences de résonance et d'antirésonance sont obtenues par l'annulation respectivement du numérateur et du dénominateur de l'équation (1). On obtient dans ce cas:

$$\omega_{r,eq} = \sqrt{\frac{1 + L_p(C_0\omega_a{}^2 + C_s\omega_r{}^2)}{2L_p(C_0 + C_s)}\left(1 \pm \sqrt{1 - \frac{4L_p(C_0 + C_s)\omega_r{}^2}{\left(1 + L_p(C_0\omega_a{}^2 + C_s\omega_r{}^2)\right)^2}}\right)},$$

$$\omega_{a,eq} = \sqrt{\left(\omega_a{}^2 + \frac{1}{L_pC_0}\right)\left(1 \pm \sqrt{1 - 4\frac{L_pC_0\omega_r{}^2}{\left(1 + L_pC_0\omega_a{}^2\right)^2}}\right)}$$

$$C_{0,eq} = C_s\frac{\omega^2 L_p C_0 - 1}{\omega^2 L_p(C_0 + C_s) - 1}$$

On constate que cette configuration produit à nouveau des résonances et antirésonances doubles. Par ailleurs, là encore, la capacité statique équivalente dépend de la fréquence et présente une plage de fréquence pour laquelle elle devient négative.

Second exemple de brique élémentaire pouvant être utilisé dans la présente invention :

Il est à noter que la configuration de la figure 8 n'est pas la seule configuration susceptible de fournir le type de comportement précédemment décrit. On peut également envisager un autre exemple de brique élémentaire. Par exemple, si l'on considère que l'élément réactif placé en parallèle au résonateur est cette fois-ci plutôt placé en parallèle de l'association en série du résonateur et le l'élément réactif placé en série, on peut obtenir le schéma de la figure 11.

Dans la suite de la description et sans perte de généralité, les développements sont traités ci-après dans le cas le plus utile en pratique, c'est-à-dire celui où l'on adjoint au résonateur deux capacités.

Dans ce cas, l'impédance équivalente de l'ensemble s'écrit :

$$Y_{eq} = \frac{1}{\dfrac{1}{Y_c\left(1 + \dfrac{r}{1 - \left(\dfrac{\omega}{\omega_r}\right)^2}\right)} + \dfrac{1}{Y_s}} + Y_p$$

Et dans ce cas on montre que :

$$\omega_{r,eq} = \omega_r \sqrt{1 + \frac{1}{\gamma} \cdot \frac{C_0}{C_0 + C_s}}$$

$$\omega_{a,eq} = \omega_r \sqrt{1 + \frac{1}{\gamma} \cdot \frac{C_0}{C_0 + \dfrac{C_s C_p}{C_s + C_p}}}$$

$$C_{0,eq} = \frac{C_s + C_p}{C_s + C_0} \cdot \left( C_0 + \frac{C_s C_p}{C_s + C_p} \right)$$

Ces expressions sont suffisamment proches de celles obtenues lors du développement de la solution (1) pour pouvoir en tirer les mêmes conclusions théoriques.

Ainsi au vu des développements précédents, il est possible selon la présente invention de définir les principales étapes suivantes du procédé de réalisation collective d'un ensemble de N filtres $F_i$ avec $1 \leq i \leq N$, chaque filtre à ondes acoustiques comportant $M_i$ résonateurs réels $R_{ij}$ à ondes acoustiques avec $1 \leq j \leq M_i$ et comportant des fréquences centrales $f_i$ et des largeurs de bande $l_i$, différentes pour au moins 2 d'entres eux.

Avantageusement, les filtres peuvent être tous réalisés sur une même puce et associés à des réactances parallèles et séries, après les étapes de conception résumées ci-après :

Etape 1 : selon cette première étape, on élabore la synthétisation de N filtres théoriques, chaque filtre étant défini à partir d'un ensemble de $M_i$ résonateur(s) théoriques avec $1 \leq j \leq M_i$ de sorte à ce que lesdits filtres théoriques présentent lesdites fréquences centrales $f_i$ et lesdites largeurs de bande $l_i$, les résonateurs théoriques de chaque filtre présentant respectivement un triplet de paramètres : une capacité statique théorique $C_{0ij,eq}$, une fréquence de résonance théorique $\omega_{rij,eq}$ et une fréquence d'antirésonance théorique $\omega_{aij,eq}$, ces paramètres étant regroupés en un ou plusieurs sous ensembles.

Etape 2 : on réalise un empilement permettant de constituer tous ces résonateurs. Par des techniques connues de l'homme de l'art, le concepteur génère une structure de résonateur de référence pour chaque sous-ensemble permettant de réaliser un résonateur possédant naturellement une fréquence de résonance inférieure à la plus faible des fréquences de résonance théoriques $\omega_{rij,eq}$ désirées, et une fréquence d'antirésonance supérieure à la plus élevée des fréquences d'antirésonance théoriques $\omega_{aij,eq}$ désirées.

Etape 3 : On détermine pour chaque résonateur théorique de chaque sous ensemble, une brique élémentaire comportant un résonateur intermédiaire $R'_{ij}$, une réactance parallèle $Xp_{ij}$ et/ou une réactance série $Xs_{ij}$, le résonateur intermédiaire $R'_{ij}$ présentant une capacité statique $C_{0ij}$, une fréquence de résonance $\omega_{r,ref}$ et une fréquence d'anti-résonance $\omega_{a,ref}$ ; les paramètres $C_{0ij}$, $Xpij$ et/ou $Xs_{ij}$ étant définis de sorte que la brique élémentaire présente une capacité statique $C_{0ij,eq}$, une fréquence de résonance $\omega_{rij,eq}$ et une fréquence d'antirésonance $\omega_{aij,eq}$.

Etape 4 : On définit les dimensionnements géométriques des résonateurs réels $R_{ij}$ des filtres, à partir du dimensionnement géométrique de la structure de résonateur de référence de sorte qu'ils présentent respectivement la capacité $C_{0ij}$ du résonateur intermédiaire $R'_{ij}$.

Premier exemple de réalisation collective utilisant des filtres à ondes de volume :

Dans cet exemple, le Demandeur a réalisé, sur une même puce, les 8 filtres d'émission et de réception de quatre duplexeurs respectant le protocole LTE dans les bandes 28, 17, 13 et 5. Les fréquences centrales et largeurs de bande de chacun des filtres d'émission et de réception pour ces bandes sont résumées dans le Tableau T1. Pour simplifier la phase de conception, il est employé une unique architecture de filtre pour ces 8 bandes de fréquence.

Tableau T1

| Bande | Fréquence centrale | | Largeur de bande |
|---|---|---|---|
| | Emission | Réception | |
| 28 | 725.5 MHz | 780.5 MHz | 45 MHz |
| 17 | 710 MHz | 740 MHz | 12 MHz |
| 13 | 782 MHz | 751 MHz | 10 MHz |
| 5 | 836.5 MHz | 881.5 MHz | 25 MHz |

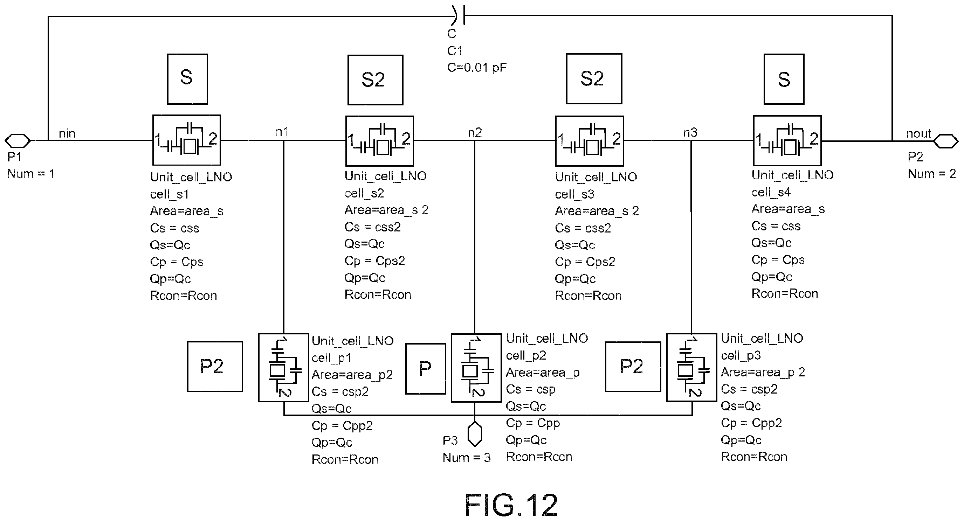

Cette architecture, illustrée figure 12, consiste en une structure en échelle à trois étages, dont chaque étage comporte une paire de briques élémentaires. Une brique contient un résonateur, caractérisé notamment par sa capacité statique et ses fréquences naturelles de résonance et d'antirésonance. Cette brique contient également une capacité en série et une capacité en parallèle. Pour chaque filtre, on s'autorise à modifier ces trois paramètres afin de synthétiser une à une les réponses de chaque filtre.

En suivant les différentes étapes de procédé de réalisation de la présente invention, on procède de la manière décrite ci-après :

Etape 1 :

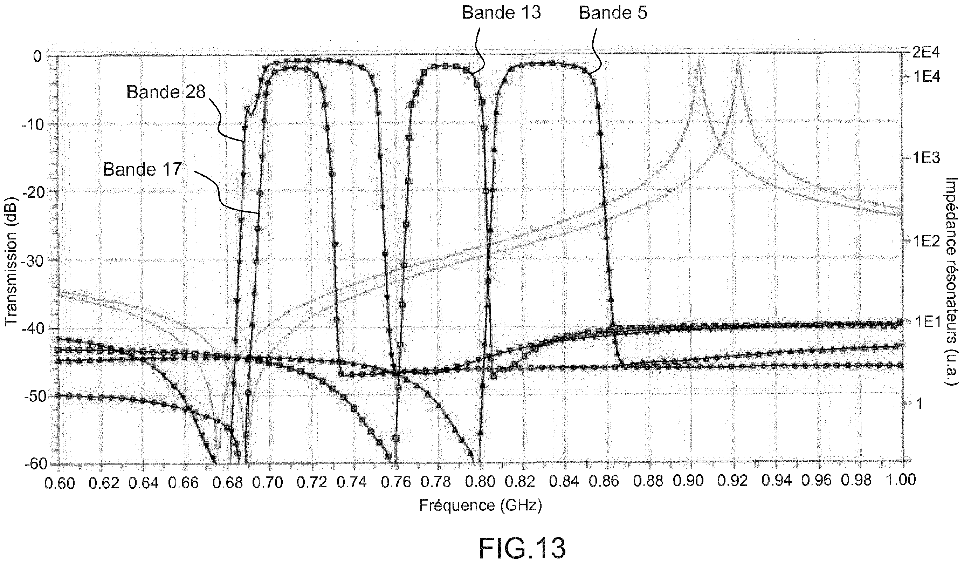

Il convient d'identifier les triplets ($C_{0eq}$, $\omega_{r,eq}$ et $\omega_{a,eq}$) propres à chaque brique de l'architecture, de manière à atteindre les spécifications requises. Pour exemple, la figure 13 montre la réponse des quatre filtres en émission ainsi constitués.

Le Tableau 2 résume l'ensemble des valeurs obtenues pendant la première phase d'optimisation

Tableau T2

| Filtres TX | Briques élémentaires | $C_{0eq}$ (pF) | $\omega_{r,eq}$ (MHz) | $\omega_{a,eq}$ (MHz) |
|---|---|---|---|---|
| Bande 28 | S | 4.6 | 716 | 769 |
| | S2 | 1.7 | 720 | 759 |
| | P | 7.8 | 673 | 711 |
| | P2 | 9 | 673 | 716 |
| Bande 17 | S | 3 | 713 | 738 |
| | S2 | 1.4 | 712 | 734 |
| | P | 14.4 | 673 | 715 |
| | P2 | 16.3 | 673 | 710 |
| Bande 13 | S | 3.9 | 784 | 805 |
| | S2 | 2.1 | 783 | 805 |
| | P | 10.4 | 750 | 783 |
| | P2 | 10.5 | 750 | 784 |
| Bande 5 | S | 2.7 | 827 | 871 |
| | S2 | 1.2 | 827 | 874 |
| | P | 8.3 | 790 | 826 |
| | P2 | 8.3 | 790 | 825 |

Une opération identique est également menée pour les quatre filtres en réception, qui permet d'identifier un nouveau jeu de valeurs pour chaque brique, résumé dans le Tableau T3 ci-après :

Tableau T3

| Filtres TX | Briques élémentaires | $C_{0eq}$ (pF) | $\omega_{r,eq}$ (MHz) | $\omega_{a,eq}$ (MHz) |
|---|---|---|---|---|
| Bande 28 | S | 2.1 | 779 | 836 |
| | S2 | 1.1 | 778 | 842 |
| | P | 6.1 | 744 | 775 |
| | P2 | 8.8 | 722 | 777 |
| Bande 17 | S | 3 4 | 744 | 774 |
| | S2 | 1.6 | 743 | 774 |
| | P | 6.6 | 714 | 742 |
| | P2 | 8.3 | 700 | 742 |
| Bande 13 | S | 2.7 | 749 | 776 |
| | S2 | 1.3 | 749 | 775 |
| | P | 8.8 | 726 | 748 |
| | P2 | 9.3 | 726 | 748 |
| Bande 5 | S | 2.1 | 878 | 919 |
| | S2 | 0.7 | 871 | 919 |
| | P | 9.1 | 838 | 877 |
| | P2 | 12.3 | 823 | 875 |

Etape 2 :

Partant de ces spécifications de briques élémentaires, le Demandeur a synthétisé un empilement basé sur des résonateurs à ondes de volume. Ces résonateurs doivent présenter une fréquence de résonance naturelle inférieure à 673 MHz (la fréquence la plus faible de toutes les briques élémentaires), et une fréquence d'antirésonance supérieure à 919 MHz (la fréquence la plus haute de toutes les briques élémentaires), soit donc un coefficient de couplage électromécanique supérieur à 60%. Pour ce faire, le Demandeur a considéré ces briques élémentaires comme appartenant à deux sous-ensembles (les briques séries et les briques parallèles), et a utilisé une couche piézoélectrique en niobate de lithium (orientation X). L'empilement utilisé est le suivant :

- Electrodes inférieures en molybdène : 190 nm d'épaisseur
- Niobate de lithium (orientation X) : 1757 nm d'épaisseur
- Electrodes supérieures en molybdène : 150 nm d'épaisseur
- Passivation en nitrure de silicium : 300 nm.

On différencie les fréquences des résonateurs disposés en série de celles des résonateurs disposés en parallèle en utilisant une surcharge massique localisée, comme habituellement utilisé sur les filtres à ondes de volume, par exemple, par une couche supplémentaire. Cette différenciation est obtenue ici en procédant à une gravure partielle par exemple de 100 nm de la couche de passivation au niveau des résonateurs série des différents filtres. La réponse électrique du couple de résonateurs ainsi réalisé est représentée sur la figure 13, échelle de droite. On assure ainsi une couverture fréquentielle compatible avec la réalisation des deux sous-ensembles de briques élémentaires.

Etapes 3 et 4 :

Enfin, les équations présentées précédemment sont utilisées pour calculer les surfaces de chaque résonateur pour chaque filtre, ainsi que les valeurs de capacités série et parallèle adjointes à chacun d'entre eux. Ces valeurs sont rassemblées dans les Tableaux T4 et T5 ci-après :

Tableau T4

| Filtres TX | Brique élémentaire | Surface résonateur ($\mu m^2$) | $C_0$(pF) | $C_s$(pF) | $C_p$(pF) |
|---|---|---|---|---|---|
| Bande 28 | S | 100x100 | 2.3 | 10.2 | 6 |
| | S2 | 60x60 | 0.8 | 5 | 1.8 |
| | P | 70x70 | 1.1 | ∞ | 6.7 |
| | P2 | 80x80 | 1.5 | ∞ | 7.5 |
| Bande 17 | S | 70x70 | 1.1 | 5.7 | 5.2 |
| | S2 | 50x50 | 0.6 | 2.8 | 2.4 |
| | P | 100x100 | 2.3 | ∞ | 12.1 |
| | P2 | 100x100 | 2.3 | ∞ | 14 |
| Bande 13 | S | 200x200 | 9.2 | 4.9 | 10.4 |
| | S2 | 150x150 | 5.2 | 2.6 | 5.9 |
| | P | 250x250 | 14.3 | 15.2 | 18.1 |
| | P2 | 250x250 | 14.3 | 15.5 | 18 |
| Bande 5 | S | 180x180 | 7.4 | 3.7 | 2.1 |
| | S2 | 125x125 | 3.6 | 1.7 | 1.1 |
| | P | 300x300 | 20.7 | 11.1 | 11.9 |
| | P2 | 300x300 | 20.7 | 11.2 | 12.1 |

Tableau T5

| Filtres TX | Brique élémentaire | Surface résonateur ($\mu m^2$) | $C_0$(pF) | $C_s$(pF) | $C_p$(pF) |
|---|---|---|---|---|---|
| Bande 28 | S | 115x115 | 3 | 3.8 | 1.8 |
| | S2 | 85x85 | 1.7 | 1.9 | 1.1 |
| | P | 185x185 | 7.8 | 9 | 11.5 |
| | P2 | 170x170 | 6.6 | 19.5 | 9.3 |
| Bande 17 | S | 115x115 | 3 | 5.3 | 6 |
| | S2 | 80x80 | 1.5 | 2.5 | 2.9 |
| | P | 135x135 | 4.2 | 11.4 | 11.4 |
| | P2 | 125x125 | 3.6 | 22.2 | 9.7 |
| Bande 13 | S | 115x115 | 3 | 3.9 | 5.9 |
| | S2 | 80x80 | 1.5 | 1.9 | 2.8 |
| | P | 190x190 | 8.3 | 12.8 | 20 |
| | P2 | 195x195 | 8.7 | 13.5 | 20.9 |
| Bande 5 | S | 200x200 | 9.2 | 2.8 | 0 |
| | S2 | 125x125 | 3.6 | 0.9 | 0 |
| | P | 400x400 | 36.7 | 11.6 | 4.9 |
| | P2 | 400x400 | 36.7 | 17.3 | 5.3 |

On note que les résonateurs des branches parallèles des filtres en émission couvrant les bandes 28 et 17 ne possèdent pas de capacité série, car dans ce cas-là on exploite directement la fréquence de résonance naturelle de l'empilement technologique, qui a été positionnée à 673 MHz, c'est-à-dire en bas de ces deux bandes.

De la même manière, le filtre de réception en bande 5 ne possède pas de capacité parallèle sur les résonateurs série. Le bord supérieur de cette bande est en effet positionné sur la fréquence d'antirésonance naturelle de l'empilement technologique, soit 919 MHz.

On montre donc que le même empilement technologique permet de réaliser de manière conjointe les filtres d'émission et de réception de quatre duplexeurs complets, soit huit filtres différents.

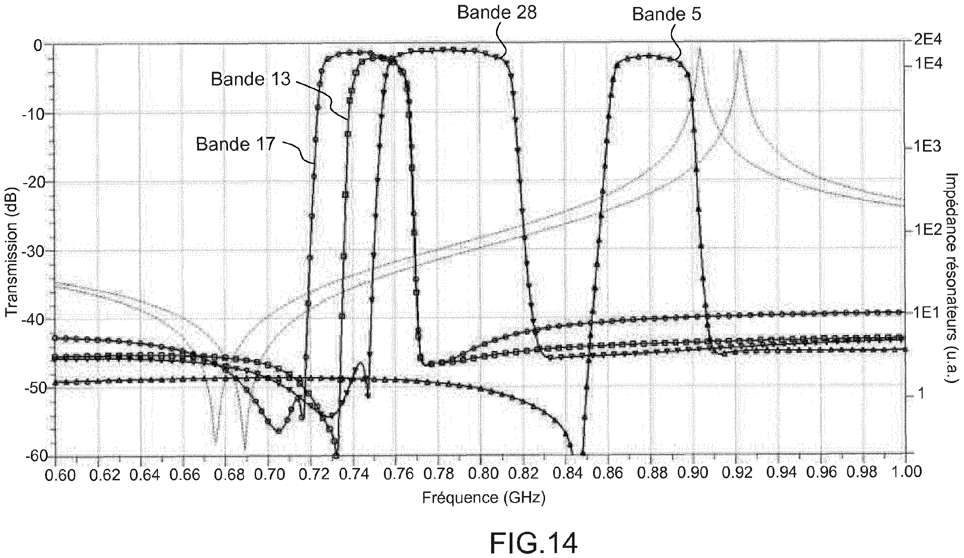

La réponse de ces filtres est représentée en figures 13 et 14.

2) Cointégration des réactances avec les résonateurs :

La manière la plus naturelle de réaliser ces filtres consiste à réaliser d'une part les différents résonateurs de ces différents filtres sur une puce, et de reporter cette puce sur une seconde puce dédiée à la réalisation de composants passifs, et notamment des capacités nécessaires au circuit de filtre. Cette façon de procéder permet de bénéficier de technologies optimisées pour la réalisation des capacités et de ne donc pas avoir à faire de compromis entre performances des capacités, des résonateurs, et des filtres.

Il a cependant été montré dans le domaine des filtres à ondes acoustiques de volume réalisés en AlN que des gains de surface considérables pouvaient être espérés en cointégrant des capacités avec les résonateurs d'un filtre. L'article de A. Volatier, G. Fattinger, F. Dumont, P. Stoyanov, R. Aigner, Technology enhancements for high performance BAW duplexer, Proceedings of the 2013 Joint UFFC, EFTF and PFM Symposium, p.761, présente par exemple la réalisation de capacités en utilisant les couches diélectriques des miroirs de Bragg de résonateurs de type SMR.

Par ailleurs, on peut remarquer que les équations (2) et (3) peuvent facilement se réécrire en normalisant les admittances $Ys$ et $Yp$ par rapport à $C_0$. En d'autres termes, les fréquences de résonance et d'antirésonance sont fixées par le rapport entre les valeurs des capacités placées en série et en parallèle au résonateur, et la capacité statique de ce résonateur. Cette dernière étant fixée par l'épaisseur de la couche piézoélectrique dans le cas de dispositifs à ondes de volume, elle est sensible à toute variation d'épaisseur survenant durant le procédé de fabrication. Ceci entraînera donc des variations de fréquences. Pour répondre à cette problématique, le Demandeur a déjà proposé et décrit dans la demande de brevet FR 2 99 60 61, de réaliser ces capacités à partir de la même couche piézoélectrique, simplement en modifiant localement l'empilement.

Pour ce faire, on réalise les résonateurs à partir d'un empilement Electrode inférieure / Couche piézoélectrique / Electrode supérieure / Couche de Passivation réalisé par-dessus une cavité libérée. A proximité de ces résonateurs, les capacités permettant de positionner les fréquences de résonance et d'antirésonance sont réalisées à partir d'un empilement Couche de collage / Electrode inférieure / Couche piézoélectrique / Electrode supérieure / Surmétallisation réalisé directement sur le substrat de manière à atténuer les résonances acoustiques pouvant être générées.

De même, les épaisseurs de couche sacrifiée et de la surmétallisation sont sélectionnées de manière à repousser ces résonances acoustiques atténuées dans des zones en fréquence où elles ne gênent pas, comme indiqué dans la demande de brevet FR 2 99 60 61.

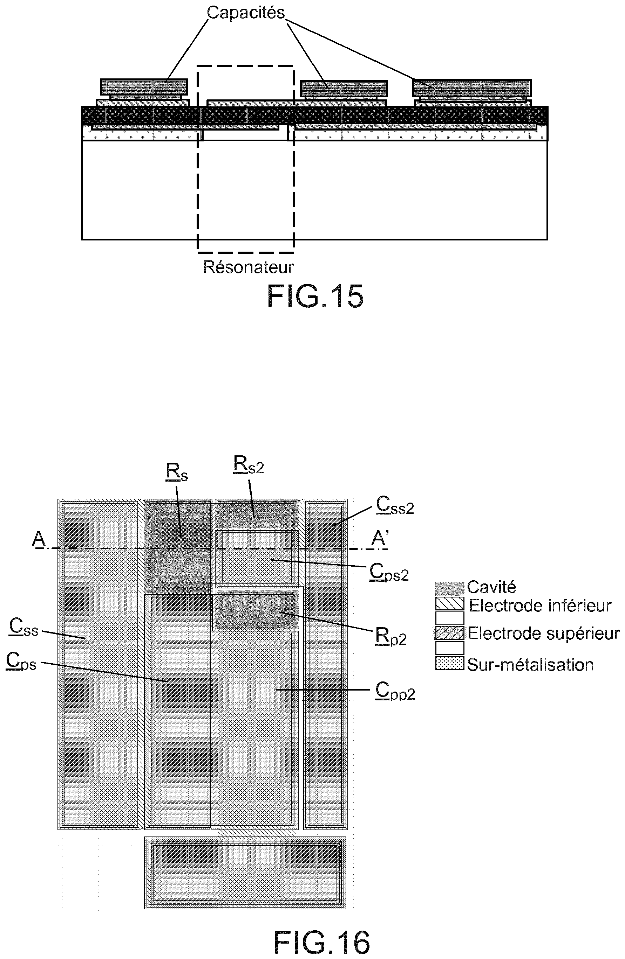

La figure 15 présente une vue schématique en coupe d'une portion de filtre incluant un résonateur et trois capacités cointégrées. Cette vue correspond à la coupe notée AA' sur la figure 16 qui représente une vue d'une portion du filtre de transmission de la bande 28 comprenant les blocs S, S2 et P2 du schéma de la figure 13. Les résonateurs de chacun des blocs sont référencés respectivement comme Rs, Rs2 et Rp2, les capacités série comme Css et Css2 (le bloc P2 ne dispose pas d'une capacité série), et les capacités parallèle comme Cps, Cps2 et Cpp2.

Second exemple de réalisation collective utilisant des filtres à ondes acoustiques de surface :

La présente invention présente aussi un avantage en vue de la cointégration de filtres à ondes acoustiques de surface. Il peut sembler trivial de cointégrer des filtres SAW sur une même puce, l'homme de l'art ayant tendance à modifier la période des peignes interdigités de manière à présenter des résonateurs possédant des fréquences de résonance et d'antirésonance différentes pour chacun des filtres cointégrés.

Néanmoins, dans ce cas, si les électrodes de ces différents résonateurs sont réalisées à partir de la même couche de métal, il en résultera des rapports épaisseur de métal / longueur d'onde distincts d'un filtre à l'autre, ce qui impacte les conditions de propagation des ondes acoustiques sous les réseaux d'électrodes, et risque de les rendre non optimales pour certains des filtres.

A l'inverse, selon l'optimisation du Demandeur, tous les résonateurs des différents filtres à cointégrer peuvent être réalisés à partir de résonateurs possédant tous la même période de peignes interdigités, et donc fonctionnant tous selon un même rapport épaisseur de métal / longueur d'onde. Ainsi, tous les résonateurs utilisent les mêmes conditions de propagation, ce qui ne nécessite pas d'optimisation spécifique d'un filtre à l'autre.

Pour illustrer l'application de la présente invention au cas de filtres à ondes acoustiques de surface, il est considéré l'utilisation d'ondes de surface de type ondes de Love se propageant à la surface d'un substrat de LiNbO$_3$ coupe (YXl)/15°, comme utilisé dans l'article de T. Komatsu, K.Y. Hashimoto, T. Omori, M. Yamaguchi, Tunable radio-frequency filters using acoustic wave resonators and variable capacitors, Japanese Journal of Applied Physics 49, 2010. , et reprenant les différentes étapes du procédé de l'invention.

Dans la mesure où le même ensemble de filtres que précédemment est conçu pour obtenir les mêmes bandes de fréquences, il est possible de repartir de la conception de filtre effectuée pour le premier exemple, et donc des spécifications de résonateurs fournies en Tableau T2 et Tableau T3.

Un résonateur à ondes acoustiques de surface est dimensionné en fixant les paramètres suivants :

- Electrodes : cuivre, épaisseur 360 nm ;
- Peignes interdigités : 2.39 $\mu$m de période, rapport de métallisation de 0.5.

L'utilisation d'électrodes de cuivre est nécessaire de manière à présenter des électrodes très denses qui viennent considérablement ralentir les ondes de surface, de manière à améliorer leur guidage le long de la surface du substrat piézoélectrique et ainsi éviter qu'elles ne viennent rayonner dans le substrat. La combinaison d'épaisseur de métal, de son rapport de métallisation et de la période des peignes interdigités permet de maximiser le coefficient de couplage électromécanique à 32 %. Ceci permet de disposer d'une fréquence de résonance localisée à 673 MHz, et d'une fréquence d'antirésonance à 773 MHz.

Ces conditions rapprochent de l'exemple précédent, même si l'on dispose d'un coefficient de couplage électromécanique plus faible. D'après les Tableau T2 et Tableau T3, il n'est possible de couvrir que les bandes d'émission 28 et 17. Pour ces deux bandes, les résonateurs sont dimensionnés de manière à présenter les capacités statiques nécessaires à la synthèse des résonateurs des bandes d'émission 28 et 17 listées dans le Tableau T2 et le Tableau T3. Ceci est effectué en ajustant la longueur de recouvrement entre doigts ainsi que le nombre d'électrodes selon les techniques connues de l'homme de l'art.

Cet exemple fait apparaître qu'un coefficient de couplage électromécanique inférieur limite rapidement le nombre de bandes qu'il est possible de couvrir.

Troisième exemple de réalisation collective utilisant des filtres à ondes de plaque :

Un troisième mode de réalisation consiste à réaliser les filtres précédents en utilisant des ondes de plaques. Ces ondes se propagent dans une membrane mince de matériau piézoélectrique. En restant dans le cas du niobate de lithium, une orientation cristalline particulièrement intéressante en vue de maximiser les coefficients de couplage électromécanique de ces ondes de plaques est la coupe dite (YXI)/30°. Cette orientation permet l'excitation d'ondes dites SH0 (*Shear Horizontal* d'ordre 0) possédant un coefficient de couplage électromécanique atteignant 55 % lorsque l'épaisseur de la plaque est proche d'un dixième de la longueur d'onde comme décrit dans l'article de M. Kadota, S. Tanaka, Y. Kuratani, T. Kimura, Ultrawide band ladder filter using SH0 plate wave in thin LiNbO3 plate and its application, Proceedings of the 2014 IEEE International Ultrasonics Symposium, pp. 2031-2034.

Comme précédemment, la procédure de mise en oeuvre ne diffère du premier exemple que par la seconde étape : la définition du résonateur. Comme mentionné dans l'article précité ci-dessus, le résonateur consiste en une membrane de niobate de lithium coupe (YXI)/30° reportée sur silicium et suspendue par-dessus une cavité usinée dans le substrat. Les ondes sont excitées par des peignes interdigités réalisés en aluminium, disposés sur la surface supérieure de la membrane et présentant une largeur de 1.4 $\mu$m et une période de 2.75 $\mu$m, la membrane présentant pour sa part une épaisseur de 550 nm et les électrodes une épaisseur de 80 nm. Un résonateur réalisé selon ces paramètres géométriques présente une fréquence de résonance proche de 664 MHz et une fréquence d'antirésonance proche de 824 MHz, et par conséquent un coefficient de couplage électromécanique de l'ordre de 48 %.

Ces conditions sont plus favorables que dans l'exemple précédent, car elles permettent, d'après les Tableau T2 et Tableau T3, de couvrir les bandes d'émission 13, 17 et 28 ainsi que les bandes de réception 13 et 17.

Pour ces 5 bandes, les résonateurs sont dimensionnés de manière à présenter les capacités statiques nécessaires à la synthèse des résonateurs de ces 5 bandes listés dans les Tableau T2 et Tableau T3. Comme précédemment, ceci est effectué en ajustant la longueur de recouvrement entre doigts ainsi que le nombre d'électrodes, selon les techniques connues de l'homme de l'art.

Avantages particuliers apportés par l'invention

La présente invention permet de réaliser une banque de filtres acoustiques sur une même puce.

Alors que selon les procédés de fabrication à l'état de l'art, chaque filtre distinct requiert un empilement technologique propre, et donc un lot de fabrication différent, l'invention permet d'employer un même lot de fabrication pour une variété importante de filtres. C'est là une optimisation du procédé de fabrication.

En conséquence, cette approche permet de minimiser le nombre de composants différents à assembler pour réaliser l'étage radiofréquence d'un système de communication, et en même temps, la surface occupée par l'ensemble de ces composants.

Si l'on regarde de plus près les données du Tableau T4 on peut évaluer la taille d'une puce contenant les 8 filtres présentés en exemple, en supposant que les capacités adjointes aux résonateurs sont positionnées sur une puce distincte, positionnée en vis-à-vis (interposeur ou circuit actif). En reprenant les surfaces de résonateurs indiquées et en considérant les marges technologiques et les dimensions des différentes interconnexions associées, on peut chiffrer la surface totale occupée par les 8 filtres à 2.5 mm$^2$ environ. Ceci est à comparer aux dimensions d'un duplexeur individuel (un couple de filtres) aux alentours de 1.5 mm$^2$ dans le meilleur des cas, pour ces bandes de fréquence. On voit donc que la cointégration des différents filtres des 4 duplexeurs étudiés sur une même puce permet un gain de surface conséquent.

**Revendications**

1. Procédé de réalisation collective d'un ensemble de N filtres $F_i$ avec $1 < i \leq N$, chaque filtre $F_i$ étant un filtre à ondes acoustiques, chaque filtre $F_i$ comportant $M_i$ résonateurs réels $R_{ij}$ à ondes acoustiques avec $1 < j \leq M_i$, chaque filtre $F_i$ comportant des fréquences centrales $f_i$ et des largeurs de bande $l_i$. différentes pour au moins 2 des filtres $F_i$, **caractérisé en ce qu'**il comporte les étapes suivantes :

   - la synthétisation de N filtres théoriques, chaque filtre étant défini à partir d'un ensemble de $M_i$ résonateur(s) à ondes acoustiques théoriques avec $1 \leq j \leq M_i$ de sorte à ce que lesdits filtres théoriques présentent lesdites fréquences centrales $f_i$ et lesdites largeurs de bande $l_i$, les résonateurs à ondes acoustiques théoriques de chaque filtre ayant une impédance d'un modèle équivalent déterminé respectivement par un triplet de paramètres : une capacité statique théorique $C_{0ij,eq}$, une fréquence de résonance théorique $\omega_{rij,eq}$ et une fréquence d'antirésonance théorique $\omega_{aij,eq}$, ces paramètres étant regroupés en un ou plusieurs sous ensembles ;
   - la détermination d'une structure de résonateur à ondes acoustiques de référence pour chaque sous-ensemble, telle que ledit résonateur de référence ait un dimensionnement géométrique tel qu'il possède naturellement une fréquence de résonance $\omega_{r,ref}$ inférieure à la plus faible des fréquences de résonance théorique $\omega_{rij,eq}$ dudit sous ensemble et une fréquence d'antirésonance $\omega_{a,ref}$ supérieure à la plus élevée des fréquences d'antirésonance théorique $\omega_{aij,eq}$, dudit sous ensemble ;
   - la détermination, à la suite de l'étape précédente pour chaque résonateur théorique de chaque sous ensemble, d'une brique élémentaire comportant un résonateur intermédiaire $R'_{ij}$, une réactance parallèle $Xp_{ij}$ et/ou une réactance série $Xs_{ij}$, le résonateur intermédiaire $R'_{ij}$ ayant une impédance d'un modèle choisis de sorte à ce que la brique élémentaire présente une capacité statique égale à la capacité statique théorique $C_{0ij,eq}$, une fréquence de résonance égale à la fréquence de résonance théorique $\omega_{rij,eq}$ et une fréquence d'antirésonance égale à la fréquence d'antirésonance théorique $\omega_{aij,eq}$ ;
   - la détermination des dimensionnements géométriques des résonateurs réels $R_{ij}$ des filtres, à partir du dimensionnement géométrique de ladite structure de résonateur de référence de sorte qu'ils présentent respectivement la capacité $C_{0ij}$ du résonateur intermédiaire $R'_{ij}$ ;
   - la réalisation de chacun desdits résonateurs réels ;
   - l'association de réactances série et/ou parallèle avec lesdits résonateurs réels pour former les briques élémentaires.

2. Procédé de réalisation collective d'un ensemble de N filtres $F_i$ selon la revendication 1, **caractérisé en ce que** la brique élémentaire comprend une réactance montée en parallèle reliée d'une part à une borne d'entrée/sortie et d'autre part à un noeud intermédiaire entre le résonateur intermédiaire et une réactance montée en série.

3. Procédé de réalisation collective d'un ensemble de N filtres $F_i$ selon la revendication 1, **caractérisé en ce que** la brique élémentaire comprend une réactance montée en parallèle de l'ensemble résonateur intermédiaire/ réactance série.

4. Procédé de réalisation collective d'un ensemble de N filtres $F_i$ selon l'une des revendications 1 à 3, **caractérisé en ce que** les filtres comprennent des briques élémentaires montées en série et des briques élémentaires montées en parallèle.

5. Procédé de réalisation collective d'un ensemble de N filtres $F_i$ selon l'une des revendications 1 à 4, **caractérisé en ce que** les résonateurs étant des résonateurs à ondes de volume, le procédé comprend :

   - la réalisation d'au moins un empilement comportant une couche d'électrode inférieure, une couche de matériau piézoélectrique, une couche d'électrode supérieure permettant de définir le résonateur de conception de référence ;
- la détermination des dimensions géométriques de la surface active des résonateurs réels.

**6.** Procédé de réalisation collective d'un ensemble de N filtres F$_i$ selon la revendication 5, **caractérisé en ce qu'**il comporte la réalisation de plusieurs empilements formés à partir d'une même couche piézoélectrique ou de plusieurs couches piézoélectriques .

**7.** Procédé de réalisation collective d'un ensemble de N filtres F$_i$ selon les revendications 4 à 6, **caractérisé en ce que** les résonateurs réels et de référence des briques élémentaires montées en parallèle comprennent une surcharge massique par rapport aux résonateurs réels et de référence des briques élémentaires montées en série.

**8.** Procédé de réalisation collective d'un ensemble de N filtres F$_i$ selon la revendication 7, **caractérisé en ce que** l'empilement comprend une couche de passivation dans laquelle l'épaisseur permet de réaliser les surcharges massiques.

**9.** Procédé de réalisation collective d'un ensemble de N filtres F$_i$ selon l'une des revendications 1 à 4, **caractérisé en ce que** les résonateurs sont des résonateurs à ondes de surface, le procédé comprend :

- la définition d'une structure de résonateur de référence comportant une structure de peignes d'électrodes inter-digitées de période $\lambda$,
- la détermination des longueurs de peignes d'électrodes interdigités de même période $\lambda$, permettant de définir les ensembles de j résonateurs réels.

**10.** Procédé de réalisation collective d'un ensemble de N filtres F$_i$ selon la revendication 9, **caractérisé en ce que** les résonateurs réels et de référence sont réalisés sur un substrat en LiNbO$_3$, pouvant être avantageusement d'orientation cristalline (YXI)/15°, les peignes d'électrodes étant réalisés en cuivre.

**11.** Procédé de réalisation collective d'un ensemble de N filtres F$_i$ selon l'une des revendications 1 à 4, **caractérisé en ce que** les résonateurs sont des résonateurs à ondes de plaque, le procédé comprend :

- la réalisation d'une membrane et d'une structure de peignes d'électrodes inter-digitées de période $\lambda$ permettant de définir un résonateur de référence ;
- la détermination des longueurs de peignes d'électrodes interdigités de même période $\lambda$, permettant de définir les ensembles de j résonateurs réels.

**12.** Procédé de réalisation collective d'un ensemble de N filtres F$_i$ selon la revendication 11, **caractérisé en ce que** les résonateurs réels et de référence sont réalisés sur un substrat en LiNbO$_3$, pouvant être avantageusement de coupe d'orientation cristalline (YXI)/30°.

**13.** Procédé de réalisation collective d'un ensemble de N filtres F$_i$ selon l'une des revendications 1 à 12, **caractérisé en ce que** l'association de réactances série et/ou parallèle avec lesdits résonateurs réels est effectuée au niveau d'une puce commune auxdits résonateurs réels et auxdites réactances.

**14.** Procédé de réalisation collective d'un ensemble de N filtres F$_i$ selon la revendication 13, **caractérisé en ce qu'**il comprend :

- la réalisation des résonateurs réels par un empilement, réalisé au-dessus d'une cavité libérée dans un substrat ;
- à proximité de ces résonateurs, la réalisation des capacités permettant de positionner les fréquences de résonance et d'antirésonance à partir d'un autre empilement.

**15.** Procédé de réalisation collective d'un ensemble de N filtres F$_i$ selon la revendication 14, **caractérisé en ce que** l'empilement formant les résonateurs et l'empilement formant les capacités comportent au moins une couche commune constituée par une couche piézoélectrique.

**Patentansprüche**

1. Verfahren zur Batch-Produktion einer Gruppe von N Filtern $F_i$, wobei $1 < i \leq N$, wobei jeder Filter $F_i$ ein Schallwellenfilter ist, wobei jeder Filter $F_i$ $M_i$ tatsächliche Schallwellenresonatoren $R_{ij}$ beinhaltet, wobei $1 < j \leq M_i$, wobei jeder Filter $F_i$ zentrale Frequenzen $f_i$ und Bandbreiten $l_i$ beinhaltet, welche für mindestens 2 der Filter $F_i$ unterschiedlich sind, **dadurch gekennzeichnet, dass** es folgende Schritte beinhaltet:

   - Synthetisieren von N theoretischen Filtern, wobei jeder Filter anhand einer Gruppe von $M_i$ theoretischen Schallwellenresonator(en) definiert wird, wobei $1 \leq j \leq M_i$, in der Weise, dass die theoretischen Filtern die zentralen Frequenzen $f_i$ und die Bandbreiten $l_i$ aufweisen, wobei die theoretischen Schallwellenresonatoren eines jeden Filters eine Impedanz eines äquivalenten Modells besitzen, welches jeweils durch ein Parameter-Tripel bestimmt wird: eine theoretische statische Kapazität $C_{0ij,eq}$, eine theoretische Resonanzfrequenz $\omega_{rij,eq}$ und eine theoretische Antiresonanzfrequenz $\omega_{aij,eq}$, wobei diese Parameter in einer oder mehreren Untergruppen zusammengefasst sind;
   - Bestimmen einer solchen Referenz-Schallwellenresonatorstruktur für jede Untergruppe, dass der Referenz-Resonator eine solche geometrische Dimensionierung besitzt, dass er naturgemäß eine Resonanzfrequenz $\omega_{r,ref}$ besitzt, welche kleiner ist als die kleinste der theoretischen Resonanzfrequenzen $\omega_{rij,eq}$ der Untergruppe und eine Antiresonanzfrequenz $\omega_{a,ref}$, welche höher ist als die höchste der theoretischen Antiresonanzfrequenzen $\omega_{aij,eq}$, der Untergruppe;
   - Bestimmen, nach dem vorhergehenden Schritt, für jeden theoretischen Resonator einer jeden Untergruppe, eines Elementarbausteins, welcher einen Zwischenresonator $R'_{ij}$, eine Parallel-Reaktanz $Xp_{ij}$ und/oder eine Reihen-Reaktanz $Xs_{ij}$ beinhaltet, wobei der Zwischenresonator $R'_{ij}$ eine Impedanz eines derartig gewählten Modells besitzt, dass der Elementarbaustein eine statische Kapazität, welche gleich einer theoretischen statischen Kapazität $C_{0ij,eq}$, ist, eine Resonanzfrequenz, welche gleich der theoretischen Resonanzfrequenz $\omega_{rij,eq}$ ist und eine Antiresonanzfrequenz, welche gleich der theoretischen Antiresonanzfrequenz $\omega_{aij,eq}$ ist, aufweist;
   - Bestimmen der geometrischen Dimensionierungen der tatsächlichen Resonatoren $R_{ij}$ der Filter anhand der geometrischen Dimensionierung der Struktur des Referenz-Resonators in der Weise, dass sie jeweils die Kapazität $C_{0ij}$ des Zwischenresonators $R'_{ij}$ aufweisen;
   - Produzieren eines jeden der tatsächlichen Resonatoren;
   - Assoziieren von Reihen- und/oder Parallel-Reaktanzen mit den tatsächlichen Resonatoren zum Bilden von Elementarbausteinen.

2. Verfahren zur Batch-Produktion einer Gruppe von N Filtern $F_i$ nach Anspruch 1, **dadurch gekennzeichnet, dass** der Elementarbaustein eine parallel geschaltete Reaktanz besitzt, welche einerseits mit einer Ein-/Ausgangsklemme verbunden ist und andererseits mit einem Zwischenknoten zwischen dem Zwischenresonator und einer in Reihe geschalteten Reaktanz verbunden ist.

3. Verfahren zur Batch-Produktion einer Gruppe von N Filtern $F_i$ nach Anspruch 1, **dadurch gekennzeichnet, dass** der Elementarbaustein eine parallel zur Baugruppe Zwischenresonator/Reihen-Reaktanz geschaltete Reaktanz besitzt.

4. Verfahren zur Batch-Produktion einer Gruppe von N Filtern $F_i$ nach einem der Ansprüche 1 bis 3, **dadurch gekennzeichnet, dass** die Filter Elementarbausteine, welche in Reihe geschaltet und Elementarbausteine, welche parallel geschaltet sind, beinhalten.

5. Verfahren zur Batch-Produktion einer Gruppe von N Filtern $F_i$ nach einem der Ansprüche 1 bis 4, **dadurch gekennzeichnet, dass**, da die Resonatoren Volumenwellenresonatoren sind, das Verfahren Folgendes beinhaltet:

   - Produzieren von mindestens einem Stapel, welcher eine untere Elektrodenschicht, eine Schicht aus piezoelektrischem Material und eine obere Elektrodenschicht beinhaltet, welche es ermöglichen, den Referenzdesign-Resonator zu definieren;
   - Bestimmen der geometrischen Dimensionen der aktiven Oberfläche der tatsächlichen Resonatoren.

6. Verfahren zur Batch-Produktion einer Gruppe von N Filtern $F_i$ nach Anspruch 5, **dadurch gekennzeichnet, dass** es die Produktion mehrerer Stapel beinhaltet, welche anhand einer gleichen piezoelektrischen Schicht oder mehrerer piezoelektrischer Schichten produziert werden.

7. Verfahren zur Batch-Produktion einer Gruppe von N Filtern $F_i$ nach den Ansprüchen 4 bis 6, **dadurch gekenn-**

**zeichnet, dass** die tatsächlichen Resonatoren und die Referenz-Resonatoren der parallel geschalteten Elementarbausteine eine Massenüberlast gegenüber den tatsächlichen Resonatoren und den Referenz-Resonatoren der in Reihe geschalteten Elementarbausteine beinhalten.

8.  Verfahren zur Batch-Produktion einer Gruppe von N Filtern $F_i$ nach Anspruch 7, **dadurch gekennzeichnet, dass** der Stapel eine Passivierungsschicht beinhaltet, in welcher die Dicke es ermöglicht, die Massenüberlasten zu produzieren.

9.  Verfahren zur Batch-Produktion einer Gruppe von N Filtern $F_i$ nach einem der Ansprüche 1 bis 4, **dadurch gekennzeichnet, dass** die Resonatoren Oberflächenwellenresonatoren sind, wobei das Verfahren Folgendes beinhaltet:

    - Definieren einer Referenz-Resonatorstruktur, welche eine ineinandergreifende Struktur von Elektrodenkämmen mit einer Periode $\lambda$ beinhaltet,
    - Bestimmen der Längen der ineinandergreifenden Elektrodenkämme mit gleicher Periode $\lambda$, welche es ermöglichen, Gruppen von j tatsächlichen Resonatoren zu definieren.

10. Verfahren zur Batch-Produktion einer Gruppe von N Filtern $F_i$ nach Anspruch 9, **dadurch gekennzeichnet, dass** die tatsächlichen und die Referenz-Resonatoren auf einem Substrat aus $LiNbO_3$ produziert werden, welches vorteilhaft eine Kristallausrichtung (YXl)/15° besitzen kann, wobei die Elektrodenkämme aus Kupfer produziert sind.

11. Verfahren zur Batch-Produktion einer Gruppe von N Filtern $F_i$ nach einem der Ansprüche 1 bis 4, **dadurch gekennzeichnet, dass** die Resonatoren Plattenwellenresonatoren sind, wobei das Verfahren Folgendes beinhaltet:

    - Produzieren einer Membran und einer Struktur aus ineinandergreifenden Elektrodenkämmen mit Periode $\lambda$, welche es ermöglichen, einen Referenz-Resonator zu definieren;
    - Bestimmen der Längen der ineinandergreifenden Elektrodenkämme mit gleicher Periode $\lambda$, welche es ermöglichen, Gruppen von j tatsächlichen Resonatoren zu definieren.

12. Verfahren zur Batch-Produktion einer Gruppe von N Filtern $F_i$ nach Anspruch 11, **dadurch gekennzeichnet, dass** die tatsächlichen und die Referenz-Resonatoren auf einem Substrat aus $LiNbO_3$ produziert werden, welches vorteilhaft eine Kristallschnittausrichtung (YXl)/30° besitzen kann.

13. Verfahren zur Batch-Produktion einer Gruppe von N Filtern $F_i$ nach einem der Ansprüche 1 bis 12, **dadurch gekennzeichnet, dass** die Assoziation von Reihen- und/oder Parallel-Reaktanzen mit den tatsächlichen Resonatoren auf Höhe eines Chips erfolgt, welcher den tatsächlichen Resonatoren und den Reaktanzen gemeinsam angehört.

14. Verfahren zur Batch-Produktion einer Gruppe von N Filtern $F_i$ nach Anspruch 13, **dadurch gekennzeichnet, dass** es Folgendes beinhaltet:

    - Produzieren von tatsächlichen Resonatoren durch einen Stapel, welcher oberhalb eines in einem Substrat frei gelassenen Hohlraums gebildet wird;
    - in der Nähe dieser Resonatoren, Produzieren der Kapazitäten, welche es ermöglichen, die Resonanzfrequenzen und die Antiresonanzfrequenzen anhand eines anderen Stapels zu positionieren.

15. Verfahren zur Batch-Produktion einer Gruppe von N Filtern $F_i$ nach Anspruch 14, **dadurch gekennzeichnet, dass** der Stapel, welcher die Resonatoren bildet und der Stapel, welcher die Kapazitäten bildet, mindestens eine gemeinsame Schicht beinhalten, welche aus einer piezoelektrischen Schicht besteht.

**Claims**

1.  A method for the batch production of a set of N filters $F_i$, where $1 < i \leq N$, each filter $F_i$ being an acoustic wave filter, each filter $F_i$ comprising $M_i$ actual acoustic wave resonators $R_{ij}$, where $1 < j \leq M_i$, each filter $F_i$ comprising center frequencies $f_i$ and bandwidths $l_i$, which are different for at least two of the filters $F_i$, **characterized in that** it comprises the following steps:

    - synthesizing N theoretical filters, each filter being defined on the basis of a set of $M_i$ theoretical acoustic wave resonator(s), where $1 \leq j \leq M_i$, such that said theoretical filters have said center frequencies $f_i$ and said bandwidths

$I_i$, the theoretical acoustic wave resonators of each filter having an impedance of an equivalent model respectively determined by a triplet of parameters: a theoretical static capacitance $C_{0ij,eq}$, a theoretical resonant frequency $\omega_{rij,eq}$ and a theoretical antiresonant frequency $\omega_{aij,eq}$, these parameters being grouped into one or more subsets;

- determining a reference acoustic wave resonator structure for each subset such that said reference resonator has geometrical dimensions such that it naturally has a resonant frequency $\omega_{r,ref}$ that is lower than the lowest of the theoretical resonant frequencies $\omega_{rij,eq}$ of said subset and an antiresonant frequency $\omega_{a,ref}$ that is higher than the highest of the theoretical antiresonant frequencies $\omega_{aij,eq}$ of said subset;

- determining, subsequent to the preceding step for each theoretical resonator of each subset, an elementary building block comprising an intermediate resonator $R'_{ij}$, a parallel reactance $Xp_{ij}$ and/or a series reactance $Xs_{ij}$, the intermediate resonator $R'_{ij}$ having an impedance of a model selected such that the elementary building block has a static capacitance that is equal to the theoretical static capacitance $C_{0ij,eq}$, a resonant frequency that is equal to the theoretical resonant frequency $\omega_{rij,eq}$ and an antiresonant frequency that is equal to the theoretical antiresonant frequency $\omega_{aij,eq}$;

- determining the geometrical dimensions of the actual resonators $R_{ij}$ of the filters on the basis of the geometrical dimensions of said reference resonator structure such that they respectively have the capacitance $C_{0ij}$ of the intermediate resonator $R'_{ij}$;

- producing each of said actual resonators;

- associating series and/or parallel reactances with said actual resonators in order to form the elementary building blocks.

2. The method for the batch production of a set of N filters $F_i$ as claimed in claim 1, **characterized in that** the elementary building block comprises a reactance connected in parallel which is connected, on the one hand, to an input/output terminal and, on the other hand, to an intermediate node between the intermediate resonator and a reactance connected in series.

3. The method for the batch production of a set of N filters $F_i$ as claimed in claim 1, **characterized in that** the elementary building block comprises a reactance connected in parallel with the intermediate resonator/series reactance assembly.

4. The method for the batch production of a set of N filters $F_i$ as claimed in one of claims 1 to 3, **characterized in that** the filters comprise elementary building blocks connected in series and elementary building blocks connected in parallel.

5. The method for the batch production of a set of N filters $F_i$ as claimed in one of claims 1 to 4, **characterized in that** as the resonators are bulk wave resonators, the method comprises:

- producing at least one stack comprising a lower electrode layer, a piezoelectric material layer and an upper electrode layer allowing the reference design resonator to be defined;
- determining the geometrical dimensions of the active area of the actual resonators.

6. The method for the batch production of a set of N filters $F_i$ as claimed in claim 5, **characterized in that** it comprises the production of multiple stacks formed on the basis of one and the same piezoelectric layer or multiple piezoelectric layers.

7. The method for the batch production of a set of N filters $F_i$ as claimed in claims 4 to 6, **characterized in that** the actual and reference resonators of the elementary building blocks connected in parallel comprise a mass overload with respect to the actual and reference resonators of the elementary building blocks connected in series.

8. The method for the batch production of a set of N filters $F_i$ as claimed in claim 7, **characterized in that** the stack comprises a passivation layer in which the thickness allows the mass overloads to be produced.

9. The method for the batch production of a set of N filters $F_i$ as claimed in one of claims 1 to 4, **characterized in that** the resonators are surface wave resonators, the method comprises:

- defining a reference resonator structure comprising an interdigitated electrode comb structure of period $\lambda$;
- determining the lengths of interdigitated electrode combs of the same period $\lambda$, allowing the sets of j actual resonators to be defined.

**10.** The method for the batch production of a set of N filters $F_i$ as claimed in claim 9, **characterized in that** the actual and reference resonators are produced on a substrate made of $LiNbO_3$, potentially and advantageously having the crystal orientation (YX1)/15°, the electrode combs being made of copper.

**11.** The method for the batch production of a set of N filters $F_i$ as claimed in one of claims 1 to 4, **characterized in that** the resonators are plate wave resonators, the method comprises:

- producing a membrane and an interdigitated electrode comb structure of period $\lambda$ allowing a reference resonator to be defined;
- determining the lengths of interdigitated electrode combs of the same period $\lambda$, allowing the sets of j actual resonators to be defined.

**12.** The method for the batch production of a set of N filters $F_i$ as claimed in claim 11, **characterized in that** the actual and reference resonators are produced on a substrate made of $LiNbO_3$, potentially and advantageously having the crystal orientation cut (YX1)/30°.

**13.** The method for the batch production of a set of N filters $F_i$ as claimed in one of claims 1 to 12, **characterized in that** the association of series and/or parallel reactances with said actual resonators is carried out on a chip common to said actual resonators and to said reactances.

**14.** The method for the batch production of a set of N filters $F_i$ as claimed in claim 13, **characterized in that** it comprises:

- producing the actual resonators by means of a stack, produced on top of a cavity left free in a substrate;
- producing, in proximity to these resonators, the capacitors allowing the resonant and antiresonant frequencies to be positioned on the basis of another stack.

**15.** The method for the batch production of a set of N filters $F_i$ as claimed in claim 14, **characterized in that** the stack forming the resonators and the stack forming the capacitors comprise at least one common layer formed by a piezoelectric layer.

FIG.1

FIG.2b

FIG.2a

EP 3 202 037 B1

FIG.2c

FIG.2d

FIG.3

FIG.4a

FIG.4b

FIG.5

FIG.6

FIG.7

Xp

R

Xs

## FIG.8

Lm

Cm

Rm

C0

R0

## FIG.9

$$\omega_a^2 = \frac{Co + Cm}{LmCmCo}$$

$$\omega_r^2 = \frac{1}{LmCm}$$

## FIG.10

## FIG.11

FIG.12

FIG.13

FIG.14

EP 3 202 037 B1

Capacités

Résonateur

## FIG.15

$R_s$ $R_{s2}$

$C_{ss2}$

A           A'

$C_{ps2}$

$R_{p2}$

$C_{ss}$

$C_{ps}$

$C_{pp2}$

Cavité
Electrode inférieur
Electrode supérieur
Sur-métalisation

## FIG.16

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 6518860 B2
- WO 2010116011 A1

- FR 2996061


**Littérature non-brevet citée dans la description**

- **K.M. LAKIN ; K.T. MCCARRON ; J. BELSICK ; R. ROSE.** Filter banks implemented with integrated thin film resonators. *Proceedings of the 2000 IEEE Ultrasonics Symposium,* 2000, 851-854
- **NAM et al.** Monolithic 1-chip FBAR duplexer for W-CDMA handsets. *Sensors and Actuators A,* 2008, vol. 143, 162-169
- **F. MARTIN ; P. MURALT ; M. CANTONI ; M.A. DUBOIS.** Re-growth of c-axis oriented AIN thin films. *Proceedings of the 2004 IEEE Ultrasonics Symposium,* 2004, 169-172
- **A. REINHARDT ; J.B. DAVID ; C. FUCHS ; M. CLEMENT ; J. OLIVARES ; E. IBORRA ; N. RIMMER ; S. BURGESS.** Multiple-frequency solidly mounted BAW filters. *Proceedings of the 2011 International Frequency Control Symposium*
- **K. Y. HASHIMOTO ; S. TANAKA ; M. ESASHI.** Tunable RF SAW/BAW filters: dream or reality?. *Joint Conference of the IEEE International Frequency Control Symposium and the European Frequency and Time Forum,* 2011

- **T. KOMATSU ; K.Y. HASHIMOTO ; T. OMORI ; M. YAMAGUCHI.** Tunable radio-frequency filters using acoustic wave resonators and variable capacitors. *Japanese Journal of Applied Physics,* 2010, vol. 49
- **T. KOMATSU ; K.Y. HASHIMOTO ; T. OMORI ; M. YAMAGUCHI.** *Tunable radio-frequency filters using acoustic wave resonators and variable capacitors*
- **A. VOLATIER ; G. FATTINGER ; F. DUMONT ; P. STOYANOV ; R. AIGNER.** Technology enhancements for high performance BAW duplexer. *Proceedings of the 2013 Joint UFFC, EFTF and PFM Symposium,* 761
- **M. KADOTA ; S. TANAKA ; Y. KURATANI ; T. KIMURA.** Ultrawide band ladder filter using SH0 plate wave in thin LiNbO3 plate and its application. *Proceedings of the 2014 IEEE International Ultrasonics Symposium,* 2014, 2031-2034